(19) Europäisches Patentamt
European Patent Office
Office européen des brevets

(11) **EP 4 460 168 A1**

(12) **EUROPEAN PATENT APPLICATION**
published in accordance with Art. 153(4) EPC

(43) Date of publication:
**06.11.2024 Bulletin 2024/45**

(21) Application number: **22943092.1**

(22) Date of filing: **25.05.2022**

(51) International Patent Classification (IPC):
***H10K 59/00*** *(2023.01)*

(52) Cooperative Patent Classification (CPC):
**H10K 59/38; H10K 50/858; H10K 50/865;**
**H10K 59/00; H10K 59/351; H10K 59/352;**
**H10K 59/353; H10K 59/65; H10K 59/879;**
**H10K 59/8792**

(86) International application number:
**PCT/CN2022/094867**

(87) International publication number:
**WO 2023/225887 (30.11.2023 Gazette 2023/48)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicants:
• **Boe Technology Group Co., Ltd.**
**Beijing 100015 (CN)**
• **Beijing BOE Technology Development Co., Ltd.**
**Beijing 100176 (CN)**

(72) Inventors:
• **HAO, Xueguang**
**Beijing 100176 (CN)**
• **QIAO, Yong**
**Beijing 100176 (CN)**
• **WU, Xinyin**
**Beijing 100176 (CN)**
• **LI, Xinguo**
**Beijing 100176 (CN)**

(74) Representative: **Durán-Corretjer, S.L.P.**
**Còrsega, 329**
**(Paseo de Gracia/Diagonal)**
**08037 Barcelona (ES)**

(54) **DISPLAY SUBSTRATE AND PREPARATION METHOD THEREFOR, AND ELECTRONIC APPARATUS**

(57)     A display substrate and a preparation method therefor, and a display apparatus. The display substrate comprises a first display area (100) and a second display area (200), which at least partially surrounds the first display area (100), wherein the first display area (100) is configured to perform image display and light transmission, and the second display area (200) is configured to perform image display; and in a plane perpendicular to the display substrate, the first display area (100) comprises at least a display structure layer, which is arranged on a base (10), and a light processing layer (50), which is arranged on the side of the display structure layer that is away from the base (10), the light-processing layer (50) comprising a light extraction structure, which is used for improving the light emission efficiency.

FIG. 6

## Description

Technical Field

The present disclosure relates to, but is not limited to, the field of display technologies, and in particular to a display substrate, a method for preparing the display substrate, and an electronic apparatus.

Background

An Organic Light Emitting Diode (OLED for short) and a Quantum dot Light Emitting Diode (QLED for short) are active light emitting display equipments and have advantages such as self-luminescence, a wide viewing angle, a high contrast ratio, low power consumption, extremely high response speed, lightness and thinness, flexibility, and low cost. With constant development of display technologies, a flexible electronic display apparatus (Flexible Display) using an OLED or a QLED as a light emitting equipment and performing signal control by use of a Thin Film Transistor (TFT for short) has become a mainstream product in the field of display at present.

Summary

The following is a summary of subject matters described herein in detail. The summary is not intended to limit the protection scope of claims.

In one aspect, the present disclosure provides a display substrate including a first display region and a second display region, the second display region at least partially surrounds the first display region, the first display region is configured to perform image display and make light pass through, and the second display region is configured to perform image display; in a plane perpendicular to the display substrate, the first display region at least includes a display structure layer disposed on the base substrate and a light-processing layer disposed on a side of the display structure layer away from the base substrate, and the light-processing layer at least includes a light-taking structure for improving light output efficiency.

In an exemplary embodiment, the light-processing layer at least includes a color filter structure layer and a first light-taking structure layer, the color filter structure layer at least includes multiple light filter layers and a black matrix arranged between the light filter layers, the first light-taking structure layer at least includes a first cover layer, multiple first light-taking structures arranged on a side of the first cover layer away from the base substrate, and a second cover layer arranged on a side of the first light-taking structure away from the base substrate, at least one first light-taking structure includes a plano-convex convex lens.

In an exemplary embodiment, the color filter structure layer is disposed on a side of the display structure layer away from the base substrate, and the first light-taking structure layer is disposed on a side of the color filter structure layer away from the base substrate.

In an exemplary embodiment, the first light-taking structure layer is arranged on a side of the display structure layer away from the base substrate, and the color filter structure layer is arranged on a side of the first light-taking structure layer away from the base substrate.

In an exemplary embodiment, an orthographic projection of the first light-taking structure on the base substrate is within the range of the light filter layer.

In an exemplary embodiment, the first cover layer has a first refractive index, the second cover layer has a second refractive index, the first light-taking structure has a first light-taking refractive index, the first light-taking refractive index is greater than or equal to the first refractive index, and the first light-taking refractive index is greater than the second refractive index.

In an exemplary embodiment, the first light-taking structure has a first height, the second cover layer has a cover thickness, and the ratio of the first height to the cover thickness is 1/3 to 1/1.1.

In an exemplary embodiment, the light-processing layer further includes a third light-taking structure layer, the third light-taking structure layer includes multiple third light-taking structures disposed on a side of the first light-taking structure layer away from the base substrate and a third cover layer disposed on a side of the multiple third light-taking structures away from the base substrate, at least one of the third light-taking structures includes a microlens group, and at least one microlens group includes multiple microlenses arranged in sequence.

In an exemplary embodiment, an orthographic projection of the third light-taking structure on the base substrate is within the range of the light filter layer.

In an exemplary embodiment, the light-processing layer at least includes a color filter structure layer and a second light-taking structure layer, the color filter structure layer at least includes multiple light filter layers and a black matrix arranged between the light filter layers, the second light-taking structure layer at least includes a first cover layer, multiple second light-taking structures arranged on a side of the first cover layer away from the base substrate, and a second cover layer arranged on a side of the second light-taking structure away from the base substrate, at least one second light-taking structure includes a prism with a trapezoidal cross section.

In an exemplary embodiment, the color filter structure layer is disposed on a side of the display structure layer away from the base substrate, and the second light-taking structure layer is disposed on a side of the color filter structure layer away from the base substrate.

In an exemplary embodiment, the second light-taking structure layer is arranged on a side of the display structure layer away from the base substrate, and the color filter structure layer is arranged on a side of the second light-taking structure layer away from the base substrate.

In an exemplary embodiment, an orthographic projection of the black matrix on the base substrate is within the range of an orthographic projection of the second light-taking structure on the base substrate.

In an exemplary embodiment, the second cover layer has a second refractive index, and the second light-taking structure has a second light-taking refractive index, and the second light-taking refractive index is less than the second refractive index.

In an exemplary embodiment, the second light-taking structure has a second height, the second cover layer has a cover thickness, and the ratio of the second height to the cover thickness is 1/3 to 1/1.2.

In an exemplary embodiment, the sidewall of the second light-taking structure has a gradient angle, the gradient angle is greater than 60° and less than 90°.

In an exemplary embodiment, the display substrate includes multiple sub-pixels in a plane parallel to the base substrate, and an orthographic projection of at least one sub-pixel on the base substrate at least partially overlaps with orthographic projections of two second light-taking structures on the base substrate.

In an exemplary embodiment, the multiple sub-pixels at least include red sub-pixels, blue sub-pixels and green sub-pixels, the sidewall of the second light-taking structure located in the region where the red sub-pixel is located has a first gradient angle, the sidewall of the second light-taking structure located in the region where the blue sub-pixel is located has a second gradient angle, and the sidewall of the second light-taking structure located in the region where the green sub-pixel is located has a third gradient angle, wherein the first gradient angle is less than the second gradient angle, and the first gradient angle is less than the third gradient angle.

In an exemplary embodiment, the light-processing layer at least includes a color filter structure layer and a composite light-taking structure layer, the color filter structure layer at least includes multiple light filter layers and a black matrix arranged between the light filter layers, the composite light-taking structure layer at least includes a first cover layer, multiple first light-taking structures and multiple second light-taking structures arranged on a side of the first cover layer away from the base substrate, and a second cover layer arranged on a side of the multiple first light-taking structures and the multiple second light-taking structures away from the base substrate, at least one first light-taking structure includes a plano-convex convex lens, and at least one second light-taking structure includes a prism with a trapezoidal cross section.

In an exemplary embodiment, the color filter structure layer is disposed on a side of the display structure layer away from the base substrate, and the composite light-taking structure layer is disposed on a side of the color filter structure layer away from the base substrate.

In an exemplary embodiment, the composite light-taking structure layer is arranged on a side of the display structure layer away from the base substrate, and the color filter structure layer is arranged on a side of the composite light-taking structure layer away from the base substrate.

In an exemplary embodiment, the orthographic projection of the first light-taking structure on the base substrate is within the range of the orthographic projection of the light filter layer on the base substrate, and the orthographic projection of the black matrix on the base substrate is within the range of the orthographic projection of the second light-taking structure on the base substrate.

In an exemplary embodiment, the first cover layer has a first refractive index, the second cover layer has a second refractive index, the first light-taking structure has a first light-taking refractive index, the second light-taking structure has a second light-taking refractive index, the first light-taking refractive index is greater than or equal to the first refractive index, the first light-taking refractive index is greater than the second refractive index, and the second light-taking refractive index is less than the second refractive index.

In an exemplary embodiment, the light-processing layer at least includes a color filter lens structure layer, and the color filter lens structure layer is a filtering and light-taking multiplex structure integrating a filtering structure and a light-taking structure.

In an exemplary embodiment, the color filter lens structure layer at least includes a black matrix, a first color filter layer, a second color filter layer, and a light filter lens layer; the black matrix is arranged at intervals on one side of the display structure layer away from the base substrate, and light-transmissive openings are formed between adjacent black matrices; the first color filter layer is respectively arranged in multiple light-transmissive openings, and the surface of the first color filter layer away from the base substrate is provided with an arc-shaped concave; the light filter lens layer is respectively arranged on the first color filter layer in multiple light-transmissive openings, and the lower surface of the arc-shaped convex in the light filter lens layer is attached to the upper surface of the arc-shaped concave in the first color filter layer; and the second color filter layer is disposed on a side of the multiple black matrices and the multiple light filter lens layers away from the base substrate.

In an exemplary embodiment, the first color filter layer has a first color filter refractive index, the second color filter layer has a second color filter refractive index, the light filter lens layer has a filter lens refractive index, the filter lens refractive index is greater than the first color filter refractive index, and the filter lens refractive index is less than the second color filter refractive index.

In an exemplary embodiment, the display structure layer at least includes a drive circuit layer arranged on the base substrate, a light emitting structure layer arranged on a side of the drive circuit layer away from the base substrate, an encapsulation structure layer arranged on a side of the light emitting structure layer away from the base substrate, and a touch control structure layer arranged on a side of the encapsulation structure layer away from the base substrate, the touch control structure layer at least includes a metal grid layer, the metal grid layer includes multiple metal wires interwoven with each other, and the orthographic projection of the metal wires on the base substrate is within at least the range of the orthographic projection of the black matrix in the light-processing layer on the base substrate.

In an exemplary embodiment, the first display region includes multiple pixel islands and multiple blank islands, in a first direction, the pixel islands and the blank islands are arranged alternately, in a second direction, the pixel islands and the blank islands are arranged alternately, and the first direction and the second direction intersect.

In an exemplary embodiment, at least one pixel island includes two pixel units, the pixel unit includes a red sub-pixel emitting red light, a blue sub-pixel emitting blue light and two green sub-pixels emitting green light, two red sub-pixels are respectively located at one diagonal position of the pixel island, two blue sub-pixels are respectively located at another diagonal position of the pixel island, and four green sub-pixels are respectively located in the middle of the second direction of the pixel island.

In an exemplary embodiment, the blank island is provided with at least one light-scattering structure, the light-scattering structure includes multiple micro-protrusions arranged in sequence, the shape of the micro-protrusions includes any one or more of triangular, rectangular, pentagonal, hexagonal, circular and elliptical in a plane parallel to the base substrate, and the cross-sectional shape of the micro-protrusions includes triangular or trapezoidal in a plane perpendicular to the base substrate.

In an exemplary embodiment, the light-scattering structure includes a first light-scattering strip arranged on both sides of the pixel island in the second direction and a second light-scattering strip respectively arranged on both sides of the pixel island in the first direction, the shape of the first light-scattering strip is a strip shape extending along the first direction, and the shape of the second light-scattering strip is a strip shape extending along the second direction.

In an exemplary embodiment, the light-scattering structure further includes a third light-scattering strip connected to the first light-scattering strip and the second light-scattering strip, respectively, the first light-scattering strip, the second light-scattering strip and the third light-scattering strip are sequentially connected to form a ring-shaped light-scattering structure surrounding the pixel island.

In an exemplary embodiment, the light-scattering structure further includes a first connection strip and a second connection strip, the first connection strip is disposed between adjacent first light-scattering strips in the second direction, and is connected with the first light-scattering strip, a connection channel is formed between the light-scattering structures adjacent to each other in the second direction, the second connection strips is disposed between adjacent second light-scattering strips in the first direction and is connected with the second light-scattering strips to form light-scattering structures that surround the pixel islands and communicate with each other, and a connection channel is formed between the light-scattering structures adjacent to each other in the first direction.

In another aspect, the present application further provides an electronic apparatus, which includes a camera apparatus and a display substrate. An orthographic projection of the camera apparatus on the display substrate at least partially overlaps with an orthographic projection of the first display region on the display substrate, and an orthographic projection of the camera apparatus on the display substrate does not overlap with an orthographic projection of the second display region on the display substrate.

In yet another aspect, the present disclosure further provides a preparation method for a display substrate. The display substrate includes a first display region and a second display region, the second display region at least partially surrounds the first display region, the first display region is configured to perform image display and make light pass through, and the second display region is configured to perform image display; the preparation method includes:

forming a display structure layer on the base substrate of the first display region; and
forming a light-processing layer on the display structure layer, and the light-processing layer at least includes a light extraction structure for improving light output efficiency.

Other aspects may be understood upon reading and understanding the drawings and detailed description.

Brief Description of Drawings

The accompanying drawings are used for providing understanding of technical solutions of the present disclosure, and form a part of the specification. They are used for explaining the technical solutions of the present disclosure together with the embodiments of the present disclosure, but do not form a limitation on the technical solutions of the present disclosure.

FIG. 1 is a schematic diagram of a structure of a display apparatus.

FIG. 2 is a schematic diagram of a structure of a display substrate.

FIG. 3 is a schematic plan view of a second display region.

FIG. 4 is a schematic diagram of an equivalent circuit of a pixel drive circuit.

FIG. 5 is a schematic plan view of a structure of a first display region according to an exemplary embodiment of the present disclosure.

FIG. 6 is a schematic sectional view of a structure of a first display region according to an exemplary embodiment of the present disclosure.

FIG. 7 is another schematic sectional view of a structure of a first display region according to an exemplary embodiment of the present disclosure.

FIG. 8 is another schematic sectional view of a structure of a first display region according to an exemplary embodiment of the present disclosure.

FIG. 9 is another schematic sectional view of a structure of a first display region according to an exemplary embodiment of the present disclosure.

FIG. 10 is another schematic sectional view of a structure of a first display region according to an exemplary embodiment of the present disclosure.

FIG. 11 is another schematic sectional view of a structure of a first display region according to an exemplary embodiment of the present disclosure.

FIG. 12 is another schematic sectional view of a structure of a first display region according to an exemplary embodiment of the present disclosure.

FIG. 13 is another schematic sectional view of a structure of a first display region according to an exemplary embodiment of the present disclosure.

FIG. 14 is another schematic sectional view of a structure of a first display region according to an exemplary embodiment of the present disclosure.

FIG. 15 is another schematic plan view of a structure of a first display region according to an exemplary embodiment of the present disclosure.

FIG. 16 is another schematic plan view of a structure of a first display region according to an exemplary embodiment of the present disclosure.

FIG. 17 is another schematic plan view of a structure of a first display region according to an exemplary embodiment of the present disclosure.

FIG. 18 is a schematic diagram after a pattern of a drive circuit layer is formed according to an exemplary embodiment of the present disclosure.

FIG. 19 is a schematic diagram of a formed pattern of a light emitting structure layer according to an exemplary embodiment of the present disclosure.

FIG. 20 is a schematic diagram after a pattern of an encapsulation structure layer is formed according to an exemplary embodiment of the present disclosure.

Description of reference signs:

| | | |
|---|---|---|
| 10-base substrate; | 20-drive circuit layer; | 21-anode; |
| 22-pixel define layer; | 23-organic light emitting layer; | 24-cathode; |
| 30-light emitting structure layer; | 31-first encapsulation layer; | 32-second encapsulation layer; |
| 33-third encapsulation layer; | 40-encapsulation structure layer; | 50-light-processing layer; |
| 60-color filter structure layer; | 61-black matrix; | 62-light filter layer; |
| 70-first light-taking structure layer; | 71-first cover layer; | 72-second cover layer; |
| 73-first light-taking structure; | 74-second light-taking structure; | 75-composite light-taking structure layer; |

(continued)

| | | |
|---|---|---|
| 80-second light-taking structure layer; | 90-third light-taking structure layer; | 91-third light-taking structure; |
| 92-third cover layer; | 100-first display region; | 110-touch control structure layer; |
| 111-metal wire; | 120-color filter lens structure layer; | 121-first color filter layer; |
| 122-second color filter layer; | 123-light filter lens layer; | 200-second display region; |
| 300-light-scattering structure; | 310-first light-scattering strip; | 320-second light-scattering strip; |
| 330-third light-scattering strip; | 340-first connection strip; | 350-second connection strip. |

Detailed Description

To make objectives, technical solutions, and advantages of the present disclosure clearer, the embodiments of the present disclosure will be described in detail with reference to the accompanying drawings. It is to be noted that implementations may be implemented in multiple different forms. Those of ordinary skills in the art may easily understand such a fact that implementations and contents may be transformed into various forms without departing from the purpose and scope of the present disclosure. Therefore, the present disclosure should not be explained as being limited to contents described in following implementations only. The embodiments in the present disclosure and features in the embodiments may be combined randomly with each other without conflict. In order to keep following description of the embodiments of the present disclosure clear and concise, detailed descriptions about part of known functions and known components are omitted in the present disclosure. The drawings of the embodiments of the present disclosure only involve structures involved in the embodiments of the present disclosure, and other structures may refer to usual designs.

Scales of the drawings in the present disclosure may be used as a reference in the actual process, but are not limited thereto. For example, the width-length ratio of the channel, the thickness and spacing of each film layer, and the width and spacing of each signal line may be adjusted according to actual needs. The number of pixels in the display substrate and the number of sub-pixels in each pixel are not limited to the numbers shown in the drawings. The drawings described in the present disclosure are schematic structure diagrams only, and one implementation of the present disclosure is not limited to the shapes, numerical values or the like shown in the drawings.

Ordinal numerals such as "first", "second", and "third" in the specification are set to avoid confusion of constituent elements, but not to set a limit in quantity.

In the specification, for convenience, wordings indicating orientation or positional relationships, such as "middle", "upper", "lower", "front", "back", "vertical", "horizontal", "top", "bottom", "inside", and "outside", are used for illustrating positional relationships between constituent elements with reference to the drawings, and are merely for facilitating the description of the specification and simplifying the description, rather than indicating or implying that a referred apparatus or element must have a particular orientation and be constructed and operated in the particular orientation. Therefore, they cannot be understood as limitations on the present disclosure. The positional relationships between the constituent elements may be changed as appropriate according to directions for describing the various constituent elements. Therefore, appropriate replacements may be made according to situations without being limited to the wordings described in the specification.

In the specification, unless otherwise specified and defined explicitly, terms "mount", "mutually connect", and "connect" should be understood in a broad sense. It may be a mechanical connection or an electrical connection. It may be a direct mutual connection, or an indirect connection through middleware, or internal communication between two components. Those of ordinary skill in the art may understand specific meanings of these terms in the present disclosure according to specific situations.

In the specification, a transistor refers to a component which at least includes three terminals, i.e., a gate electrode, a drain electrode and a source electrode. The transistor has a channel region between the drain electrode (drain electrode terminal, drain region, or drain) and the source electrode (source electrode terminal, source region, or source), and a current may flow through the drain electrode, the channel region, and the source electrode. It is to be noted that, in the specification, the channel region refers to a region through which the current mainly flows.

In the specification, a first electrode may be a drain electrode, and a second electrode may be a source electrode. Or, the first electrode may be the source electrode, and the second electrode may be the drain electrode. In cases that transistors with opposite polarities are used, a current direction changes during operation of a circuit, or the like, functions of the "source electrode" and the "drain electrode" are sometimes interchangeable. Therefore, the "source electrode" and the "drain electrode", as well as the "source terminal" and the "drain terminal" are interchangeable in the specification.

In the specification, "electrical connection" includes a case that constituent elements are connected together through an element with a certain electrical effect. The "element with the certain electrical effect" is not particularly limited as long as electrical signals may be sent and received between the connected constituent elements. Examples of the "element with the certain electrical effect" not only include electrodes and wirings, but further include switch elements such as transistors, resistors, inductors, capacitors, other elements with various functions, etc.

In the specification, "parallel" refers to a state in which an angle formed by two straight lines is above -10° and below 10°, and thus further includes a state in which the angle is above -5° and below 5°. In addition, "perpendicular" refers to a state in which an angle formed by two straight lines is above 80° and below 100°, and thus further includes a state in which the angle is above 85° and below 95°.

In the specification, a "thin film" and a "layer" are interchangeable. For example, a "conductive layer" may be replaced with a "conductive thin film" sometimes. Similarly, an "insulation thin film" may be replaced with an "insulation layer" sometimes.

Triangle, rectangle, trapezoid, pentagon and hexagon in this specification are not strictly defined, and they may be approximate triangle, rectangle, trapezoid, pentagon or hexagon, etc. There may be some small deformation caused by tolerance, and there may be chamfer, arc edge and deformation, etc.

In the present disclosure, "about" refers to that a boundary is defined not so strictly and numerical values within process and measurement error ranges are allowed.

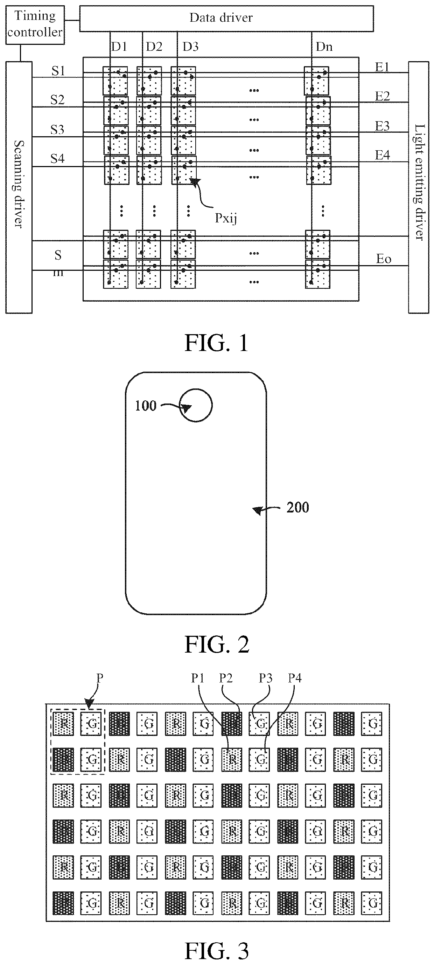

FIG. 1 is a schematic diagram of a structure of a display apparatus. As shown in FIG. 1, the display apparatus may include a timing controller, a data driver, a scan driver, a light emitting driver and a pixel array. The timing controller is connected to the data driver, the scan driver and the light emitting driver, respectively, the data driver is connected to multiple data signal lines (D1 to Dn) respectively, the scan driver is connected to multiple scan signal lines (S1 to Sm) respectively, and the light emitting driver is connected to multiple light emitting signal lines (E1 to Eo) respectively. The pixel array may include multiple sub-pixels Pxij, i and j may be natural numbers. At least one sub-pixel Pxij may include a circuit unit and a light emitting equipment connected to the circuit unit. The circuit unit may include a pixel drive circuit connected to a scan signal line, a data signal line and a light emitting signal line. In an exemplary implementation, the timing controller may provide a gray tone value and a control signal, which are suitable for a specification of the data driver, to the data driver, provide a clock signal, a scan start signal, etc., which are suitable for a specification of the scan driver, to the scan driver, and provide a clock signal, a transmit stop signal, etc., which are suitable for a specification of the light emitting driver, to the light emitting driver. The data driver may generate data voltages to be provided to data signal lines D1, D2, D3, ..., and Dn using the gray scale value and the control signal received from the timing controller. For example, the data driver may sample the gray tone value by using the clock signal and apply a data voltage corresponding to the gray tone value to the data signal lines D1 to Dn by taking a pixel row as a unit, wherein n may be a natural number. The scan driver may generate scan signals to be provided to scan signal lines S1, S2, S3, ..., and Sm by receiving a clock signal, a scanning start signal, and the like from the timing controller. For example, the scan driver may provide a scan signal with an on-level pulse to the scan signal lines S1 to Sm sequentially. For example, the scan driver may be constructed in a form of a shift register and may generate a scan signal in a manner in which the scan start signal provided in a form of an on-level pulse is transmitted to a next-stage circuit sequentially under the control of the clock signal, wherein m may be a natural number. The light emitting driver may generate transmission signals to be provided to light emitting line emitting lines E1, E2, E3, ..., and Eo by receiving the clock signal, the transmission stop signal, and the like from the timing controller. For example, the light emitting driver may provide a transmit signal with an off-level pulse to the light emitting signal lines E1 to Eo sequentially. For example, the light emitting driver may be constructed in a form of a shift register and may generate a transmit signal in a manner in which the transmit stop signal provided in a form of an off-level pulse is transmitted to a next-stage circuit sequentially under the control of the clock signal, wherein o may be a natural number.

With the development of display technology, products such as full screen or narrow bezel have gradually become the development trend of display products because of their large screen proportion and ultra-narrow bezel. For electronic products such as intelligent terminals, hardware such as front camera, fingerprint sensor or light sensor is usually required. In order to increase the proportion of screens, full-screen or narrow-bezel products usually adopt Full display with camera (FDC for short) technology or under-screen fingerprint technology, and sensors such as cameras are placed in the Under Display Camera (UDC) of the display substrate. The under-screen camera region not only has a certain transmittance, but also has a display function, achieving Full Display in Camera region (FDC for short).

FIG. 2 is a schematic diagram of a structure of a display substrate. As shown in FIG. 2, on a plane parallel to the display substrate, the display substrate may include a first display region 100 and a second display region 200, and the second display region 200 may at least partially surround the first display region 100. In an exemplary embodiment, the position of the first display region 100 may correspond to the position of the optical apparatus, the first display region 100 configured to perform image display and make light pass through, the passed-through light is received by the optical apparatus, and the first display region 100 may be referred to as an under display camera display region. The second display region 200 is configured to perform image display and may be referred to as a normal display region.

In an exemplary embodiment, the position of the first display region 100 in the second display region 200 may be unlimited, and may be located at the top or bottom of the second display region 200, or may be located at the edge of the second display region 200. In an exemplary implementation mode, in a plane parallel to the display substrate, a shape of the first display region 100 may be any one or more of following: a square, a rectangle, a polygon, a circle, and an ellipse, and the optical apparatus may be an optical sensor such as a fingerprint recognition apparatus, a camera apparatus, or a 3D imaging apparatus. When the shape of the first display region 100 is circular, the diameter of the circle may be about 3mm to 5mm, and when the shape of the first display region 100 is rectangular, the side length of the rectangle may be about 3mm to 5mm, which is not limited herein.

In an exemplary embodiment, the resolutions of the first display region 100 and the second display region 200 may be the same, or the resolution of the first display region 100 may be less than the resolution of the second display region 200. For example, the resolution of the first display region 100 may be about 50% to 70% of the resolution of the second display region 200. Pixels Per Inch (PPI) refers to the number of pixels per unit area. The higher the PPI value, the higher the density of the display substrate can display the picture and the richer the details of the picture.

FIG. 3 is a schematic plan view of a second display region. As shown in FIG. 3, the second display region may include multiple pixel units P arranged in a regular arrangement. At least one pixel unit P includes a first sub-pixel P1 emitting light of a first color, a second sub-pixel P2 emitting light of a second color, a third sub-pixel P3 emitting light of a third color, and a fourth sub-pixel P4 emitting light of a fourth color. Each sub-pixel may include a circuit unit and a light emitting equipment, and the circuit unit may include a pixel drive circuit and a scan signal line, a data signal line, and a light emitting signal line connected to the pixel drive circuit, etc. The pixel drive circuit is configured to receive a data voltage transmitted by the data signal line under control of the scan signal line and the light emitting signal line, and output a corresponding current to the light emitting equipment. The light emitting equipment in each sub-pixel is connected with a pixel drive circuit of a sub-pixel where the light emitting equipment is located, and is configured to emit light with a corresponding brightness in response to a current output by the pixel drive circuit of the sub-pixel where the light emitting equipment is located.

In an exemplary implementation, the first sub-pixel P1 may be a red sub-pixel (R) emitting red light, the second sub-pixel P2 may be a blue sub-pixel (B) emitting blue light, and the third sub-pixel P3 and the fourth sub-pixel P4 may be green sub-pixels (G) emitting green light. In an exemplary embodiment, a shape of the sub-pixel may be rectangular, rhombus, pentagonal or hexagonal, and the four sub-pixels in the pixel unit P may be arranged horizontally, vertically or squarely, which is not limited in this disclosure.

In an exemplary implementation, the pixel unit may include three sub-pixels, wherein the three sub-pixels may be arranged side by side horizontally, side by side vertically, or in a form of pyramid, which is not limited in the present disclosure.

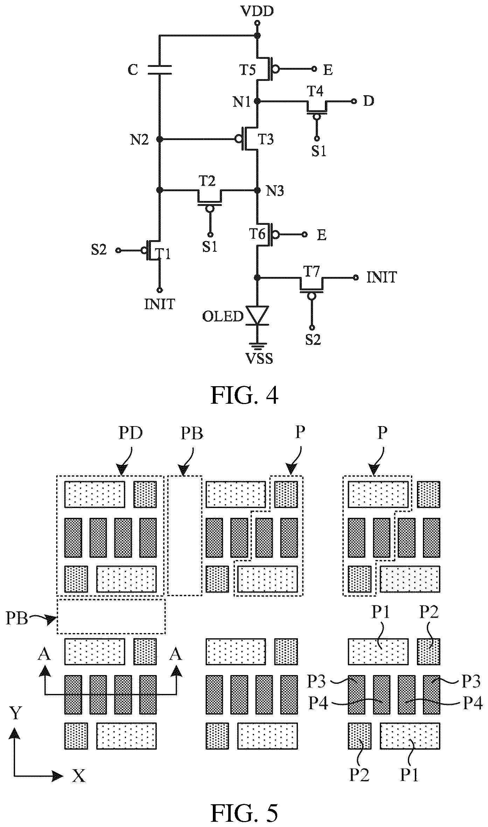

FIG. 4 is a schematic diagram of an equivalent circuit of a pixel drive circuit. In an exemplary implementation, the pixel drive circuit may be in a 3T1C, 4T1C, 5T1C, 5T2C, 6T1C, or 7T1C structure. As shown in FIG. 4, the pixel drive circuit may include seven transistors (a transistor T1 to a seventh transistor T7), one storage capacitor C. The pixel drive circuit is connected with seven signal lines (a data signal line D, a first scan signal line S1, a second scan signal line S2, a light emitting signal line E, an initial signal line INIT, a first power supply line VDD, and a second power supply line VSS).

In an exemplary implementation, the pixel drive circuit may include a first node N1, a second node N2, and a third node N3. Herein, the first node N1 is respectively connected with a first electrode of the third transistor T3, a second electrode of the fourth transistor T4, and a second electrode of the fifth transistor T5, the second node N2 is respectively connected with a second electrode of the transistor, a first electrode of the second transistor T2, a control electrode of the third transistor T3, and a second end of the storage capacitor C, and the third node N3 is respectively connected with a second electrode of the second transistor T2, a second electrode of the third transistor T3, and a first electrode of the sixth transistor T6.

In an exemplary implementation, a first end of the storage capacitor C is connected with the first power supply line VDD, and the second end of the storage capacitor C is connected with the second node N2, i.e., the second end of the storage capacitor C is connected with the control electrode of the third transistor T3.

A control electrode of the transistor T1 is connected with the second scan signal line S2, a first electrode of the transistor T1 is connected with an initial signal line INIT, and the second electrode of the transistor is connected with the second node N2. When a scan signal with an on-level is applied to the second scan signal line S2, the transistor T1 transmits an initialization voltage to the control electrode of the third transistor T3 so as to initialize a charge amount of the control electrode of the third transistor T3.

A control electrode of the second transistor T2 is connected with the first scan signal line S1, the first electrode of the second transistor T2 is connected with the second node N2, and the second electrode of the second transistor T2 is connected with the third node N3. When a scan signal with an on-level is applied to the first scan signal line S1, the second transistor T2 enables the control electrode of the third transistor T3 to be connected with a second electrode of the third transistor T3.

The control electrode of the third transistor T3 is connected with the second node N2, i.e., the control electrode of the third transistor T3 is connected with the second end of the storage capacitor C, a first electrode of the third transistor T3 is connected with the first node N1, and the second electrode of the third transistor T3 is connected with the third node N3. The third transistor T3 may be referred to as a drive transistor, and the third transistor T3 determines an amount of a drive current flowing between the first power supply line VDD and the second power supply line VSS according to a potential difference between the control electrode and the first electrode of the third transistor T3.

A control electrode of the fourth transistor T4 is connected with the first scan signal line S1, a first electrode of the fourth transistor T4 is connected with the data signal line D, and a second electrode of the fourth transistor T4 is connected with the first node N1. The fourth transistor T4 may be referred to as a switch transistor, a scan transistor, etc., and when a scan signal with an on-level is applied to the first scan signal line S1, the fourth transistor T4 enables a data voltage of the data signal line D to be input to the pixel drive circuit.

A control electrode of the fifth transistor T5 is connected with the light emitting signal line E, a first electrode of the fifth transistor T5 is connected with the first power supply line VDD, and a second electrode of the fifth transistor T5 is connected with the first node N1. A control electrode of the sixth transistor T6 is connected with the light emitting signal line E, a first electrode of the sixth transistor T6 is connected with the third node N3, and a second electrode of the sixth transistor T6 is connected with a first electrode of a light emitting equipment. The fifth transistor T5 and the sixth transistor T6 may be referred to as light emitting transistors. When a light emitting signal with an on-level is applied to the light emitting signal line E, the fifth transistor T5 and the sixth transistor T6 enable the light emitting equipment to emit light by forming a drive current path between the first power supply line VDD and the second power supply line VSS.

A control electrode of the seventh transistor T7 is connected with the second scan signal line S2, a first electrode of the seventh transistor T7 is connected with the initial signal line INIT, and a second electrode of the seventh transistor T7 is connected with the first electrode of the light emitting equipment. When an on-level scan signal is applied to the second scan signal line S2, the seventh transistor T7 transmits an initialization voltage to the first electrode of the light emitting equipment so as to initialize a charge amount accumulated in the first electrode of the light emitting equipment or release a charge amount accumulated in the first electrode of the light emitting equipment.

In an exemplary implementation, the light emitting equipment may be an OLED including a first electrode (anode), an organic light emitting layer, and a second electrode (cathode), which are stacked, or may be a QLED including a first electrode (anode), a quantum dot light emitting layer, and a second electrode (cathode), which are stacked.

In an exemplary implementation, a second electrode of the light emitting equipment is connected with the second power supply line VSS, a signal of the second power supply line VSS is a low-level signal, and a signal of the first power supply line VDD is a high-level signal continuously provided.

In an exemplary implementation, the transistor T1 to the seventh transistor T7 may be P-type transistors or N-type transistors. Use of a same type of transistors in a pixel drive circuit may simplify a process flow, reduce process difficulties of a display panel, and improve a product yield. In some possible implementations, the transistor T1 to the seventh transistor T7 may include P-type transistors and N-type transistors.

In an exemplary implementation, the transistor T1 to the seventh transistor T7 may be low temperature poly silicon thin film transistors, or may be oxide thin film transistors, or may be low temperature poly silicon thin film transistors and oxide thin film transistors. An active layer of a low temperature poly silicon thin film transistor may be made of Low Temperature Poly Silicon (LTPS for short), and an active layer of an oxide thin film transistor may be made of an oxide semiconductor (Oxide). The low temperature polysilicon thin film transistor has advantages such as high migration rate and fast charging. The oxide thin film transistor has advantages such as low drain current. The low temperature polysilicon thin film transistor and the oxide thin film transistor are integrated on one display substrate to form a Low Temperature Polycrystalline Oxide (LTPO for short) display substrate, so that advantages of the low temperature polysilicon thin film transistor and the oxide thin film transistor may be utilized, low-frequency drive may be achieved, power consumption may be reduced, and display quality may be improved.

In an exemplary implementation, the light emitting equipment may be an organic light emitting diode (OLED), including a first electrode (anode), an organic light emitting layer, and a second electrode (cathode) that are stacked.

In an exemplary embodiment, taking the seven transistors in the pixel drive circuit shown in FIG. 4 are all P-type transistors as an example, the operation process of the pixel drive circuit may include:

In a first stage A1, referred to as a reset stage, a signal of the second scan signal line S2 is a low-level signal, and signals of the first scan signal line S1 and the light emitting signal line E are high-level signals. The signal of the second scan signal line S2 is a low-level signals, which causes the first transistor T1 and the seventh transistor T7 to be turned on. The first transistor T1 is turned on such that the initial voltage of the initial signal line INIT is provided to a second node N2 to initialize (reset) the storage capacitor C to clear an original data voltage in the storage capacitor. The seventh transistor T7 is turned on, so that an initialization voltage of the initial signal line INIT is provided to a first electrode of the OLED to initialize (reset) the first electrode of the OLED and clear a pre-stored voltage therein, thereby completing initialization to ensure that the OLED does not emit light. The signals of the first scan signal line S1 and the light emitting signal line E are high-level signals, so that the second transistor T2, the fourth transistor T4, the fifth transistor T5, and the sixth transistor T6 are turned off.

In a second stage A2, referred to as a data writing stage or a threshold compensation stage, the signal of the first scan signal line S1 is a low-level signal, signals of the second scan signal line S2 and the light emitting signal line E are high-level signals, and the data signal line D outputs a data voltage. In this stage, a second end of the storage capacitor C is at a low level, so the third transistor T3 is turned on. The signal of the first scan signal line S1 is a low-level signal, so that the second transistor T2, the fourth transistor T4, and the seventh transistor T7 are turned on. The second transistor T2 and the fourth transistor T4 are turned on, so that the data voltage output by the data signal line D is provided to the second node N2 through a first node N1, the turned-on third transistor T3, a third node N3, and the turned-on second transistor T2, and the storage capacitor C is charged with a difference between the data voltage output by the data signal line D and a threshold voltage of the third transistor T3. A voltage at the second end (the second node N2) of the storage capacitor C is Vd-IVthl, wherein Vd is the data voltage output by the data signal line D, and Vth is the threshold voltage of the third transistor T3. The signal of the second scan signal line S2 is the high-level signal, so that the first transistor T1 and the seventh transistor T7 are turned off. The signal of the light emitting signal line E is a high-level signal, so that the fifth transistor T5 and the sixth transistor T6 are turned off.

In a third stage A3, referred to as a light emitting stage, the signal of the light emitting signal line E is a low-level signal, and the signals of the first scan signal line S1 and the second scan signal line S2 are high-level signals. The signal of the light emitting signal line E is a low-level signal, so that the fifth transistor T5 and the sixth transistor T6 are turned on, and a power voltage output by the first power supply line VDD provides a drive voltage to the first electrode of the OLED through the turned-on fifth transistor T5, third transistor T3, and sixth transistor T6 to drive the OLED to emit light.

In a drive process of the pixel drive circuit, a drive current flowing through the third transistor T3 (drive transistor) is determined by a voltage difference between a gate electrode and a first electrode of the third transistor T3. The voltage of the second node N2 is Vdata-IVthl, so the drive current of the third transistor T3 is as follows.

$$I = K*(Vgs-Vth)^2 = K*[(Vdd-Vd+|Vth|)-Vth]^2 = K*[(Vdd-Vd]^2$$

Herein, I is the drive current flowing through the third transistor T3, i.e., a drive current for driving the OLED, K is a constant, Vgs is the voltage difference between the gate electrode and the first electrode of the third transistor T3, Vth is the threshold voltage of the third transistor T3, Vd is the data voltage output by the data signal line D, and Vdd is the power voltage output by the first power supply line VDD.

Exemplary embodiments of the present disclosure provide a display substrate including a first display region and a second display region, the second display region at least partially surrounds the first display region, the first display region is configured to perform image display and make light pass through, and the second display region is configured to perform image display; in a plane perpendicular to the display substrate, the first display region at least includes a display structure layer disposed on the base substrate and a light-processing layer disposed on a side of the display structure layer away from the base substrate, and the light-processing layer at least includes a light-taking structure for improving light output efficiency.

In an exemplary embodiment, the light-processing layer at least includes a color filter structure layer and a first light-taking structure layer, the color filter structure layer at least includes multiple light filter layers and a black matrix arranged between the light filter layers, the first light-taking structure layer at least includes a first cover layer, multiple first light-taking structures arranged on a side of the first cover layer away from the base substrate, and a second cover layer arranged on a side of the first light-taking structure away from the base substrate, at least one first light-taking structure includes a plano-convex convex lens.

In an exemplary embodiment, the color filter structure layer is disposed on a side of the display structure layer away from the base substrate, and the first light-taking structure layer is disposed on a side of the color filter structure layer away from the base substrate; alternatively, the first light-taking structure layer is arranged on a side of the display structure layer away from the base substrate, and the color filter structure layer is arranged on a side of the first light-taking structure layer away from the base substrate.

In another exemplary embodiment, the light-processing layer at least includes a color filter structure layer and a second light-taking structure layer, the color filter structure layer at least includes multiple light filter layers and a black matrix arranged between the light filter layers, the second light-taking structure layer at least includes a first cover layer, multiple second light-taking structures arranged on a side of the first cover layer away from the base substrate, and a second cover layer arranged on a side of the second light-taking structure away from the base substrate, at least one second light-taking structure includes a prism with a trapezoidal cross section.

In an exemplary embodiment, the color filter structure layer is disposed on a side of the display structure layer away from the base substrate, and the second light-taking structure layer is disposed on a side of the color filter structure layer away from the base substrate; alternatively, the second light-taking structure layer is arranged on a side of the display structure layer away from the base substrate, and the color filter structure layer is arranged on a side of the second light-taking structure layer away from the base substrate.

In another exemplary embodiment, the light-processing layer at least includes a color filter structure layer and a composite light-taking structure layer, the color filter structure layer at least includes multiple light filter layers and a black matrix arranged between the light filter layers, the composite light-taking structure layer at least includes a first cover layer, multiple first light-taking structures and multiple second light-taking structures arranged on a side of the first cover layer away from the base substrate, and a second cover layer arranged on a side of the multiple first light-taking structures and the multiple second light-taking structures away from the base substrate, at least one first light-taking structure includes a plano-convex convex lens, and at least one second light-taking structure includes a prism with a trapezoidal cross section.

In an exemplary embodiment, the color filter structure layer is disposed on a side of the display structure layer away from the base substrate, and the composite light-taking structure layer is disposed on a side of the color filter structure layer away from the base substrate; alternatively the composite light-taking structure layer is arranged on a side of the display structure layer away from the base substrate, and the color filter structure layer is arranged on a side of the composite light-taking structure layer away from the base substrate.

In another exemplary embodiment, the light-processing layer at least includes a color filter lens structure layer, and the color filter lens structure layer is a filtering and light-taking multiplex structure integrating a filtering structure and a light-taking structure.

In an exemplary embodiment, the color filter lens structure layer at least includes a black matrix, a first color filter layer, a second color filter layer, and a light filter lens layer; the black matrix is arranged at intervals on one side of the display structure layer away from the base substrate, and light-transmissive openings are formed between adjacent black matrices; the first color filter layer is respectively arranged in multiple light-transmissive openings, and the surface of the first color filter layer away from the base substrate is provided with an arc-shaped concave; the light filter lens layer is respectively arranged on the first color filter layer in multiple light-transmissive openings, and the lower surface of the arc-shaped convex in the light filter lens layer is attached to the upper surface of the arc-shaped concave in the first color filter layer; and the second color filter layer is disposed on a side of the multiple black matrices and the multiple light filter lens layers away from the base substrate.

In an exemplary embodiment, the display structure layer at least includes a drive circuit layer arranged on the base substrate, a light emitting structure layer arranged on a side of the drive circuit layer away from the base substrate, an encapsulation structure layer arranged on a side of the light emitting structure layer away from the base substrate, and a touch control structure layer arranged on a side of the encapsulation structure layer away from the base substrate, the touch control structure layer at least includes a metal grid layer, the metal grid layer includes multiple metal wires interwoven with each other, and the orthographic projection of the metal wires on the base substrate is within at least the range of the orthographic projection of the black matrix in the light-processing layer on the base substrate.

In an exemplary embodiment, the first display region includes multiple pixel islands and multiple blank islands, in a first direction, the pixel islands and the blank islands are arranged alternately, in a second direction, the pixel islands and the blank islands are arranged alternately, and the first direction and the second direction intersect.

In an exemplary embodiment, at least one pixel island includes two pixel units, the pixel unit includes one red sub-pixel emitting red light, one blue sub-pixel emitting blue light and two green sub-pixels emitting green light, two red sub-pixels are respectively located at one diagonal position of the pixel island, two blue sub-pixels are respectively located at another diagonal position of the pixel island, and four green sub-pixels are respectively located in the middle of the second direction of the pixel island.

In an exemplary embodiment, the blank island is provided with at least one light-scattering structure, the light-scattering structure includes multiple micro-protrusions arranged in sequence, the shape of the micro-protrusions includes any one or more of triangular, rectangular, pentagonal, hexagonal, circular and elliptical in a plane parallel to the base substrate, and the cross-sectional shape of the micro-protrusions includes triangular, rectangular, or trapezoidal in a plane perpendicular to the base substrate.

FIG. 5 is a schematic plan view of a structure of a first display region according to an exemplary embodiment of the present disclosure. As shown in FIG. 5, the first display region may include multiple pixel islands PD and multiple blank islands PB. In the first direction X, pixel islands PD and blank islands PB are alternately arranged, and in the second direction Y, pixel islands PD and blank islands PB are alternately arranged, so that blank islands PB are provided between adjacent pixel islands PD in the first direction X and between adjacent pixel islands PD in the second direction Y. The blank islands PB form a space between pixel islands PD, and the first direction X and the second direction Y intersect.

In an exemplary embodiment, at least one pixel island PD may include two pixel units P, each pixel unit P includes a first sub-pixel P1 emitting light of a first color, a second sub-pixel P2 emitting light of a second color, a third sub-pixel P3 and a fourth sub-pixel P4 emitting light of a third color. Thus, one pixel island PD may include two first sub-pixels P1, two second sub-pixels P2, two third sub-pixels P3 and two fourth sub-pixels P4.

In an exemplary embodiment, in at least one pixel island PD, two first sub-pixels P1 may be located at one diagonal position of the pixel island PD, two second sub-pixels P2 may be located at another diagonal position of the pixel island PD, and two third sub-pixels P3 and two fourth sub-pixels P4 are both located in the middle of the second direction Y of the pixel island PD. For example, the two first sub-pixels P1 may be respectively located in the upper left corner and the lower right corner of the pixel island PD, two second sub-pixels P2 may be respectively located in the upper right corner and lower left corner of the pixel island PD, two third sub-pixels P3 and two fourth sub-pixels P4 are both located in the middle of the second direction Y of the pixel island PD, two third sub-pixels P3 are respectively located on the left side and right side of the first direction X of the pixel island PD, and two fourth sub-pixels P4 are respectively located between the two third sub-pixels P3.

In an exemplary embodiment, on a plane parallel to the display substrate, the shapes of the first sub-pixel P1, the second sub-pixel P2, the third sub-pixel P3 and the fourth sub-pixel P4 may be rectangle, rhombus, pentagon or hexagon, etc., which are not limited in this disclosure.

In an exemplary embodiment, the area of the first sub-pixel P1, the second sub-pixel P2, the third sub-pixel P3 and the fourth sub-pixel P4 may be the same or different, and the present disclosure is not limited herein.

In an exemplary implementation, the first sub-pixel P1 may be a red (R) sub-pixel emitting red light, the second sub-pixel P2 may be a blue (B) sub-pixel emitting blue light, and the third sub-pixel P3 and the fourth sub-pixel P4 may be green (G) sub-pixels emitting green light.

In an exemplary embodiment, since the four green sub-pixels are located in the middle of the pixel island PD in the second direction Y, and are arranged sequentially along the first direction X, in the process of evaporating the organic light emitting layer, the organic light emitting layer of four green sub-pixels may be evaporated simultaneously in a co-evaporation mode, and the organic light emitting layers of the four green sub-pixels are common layers connected together, which can effectively reduce the evaporation process time and reduce the evaporation process cost.

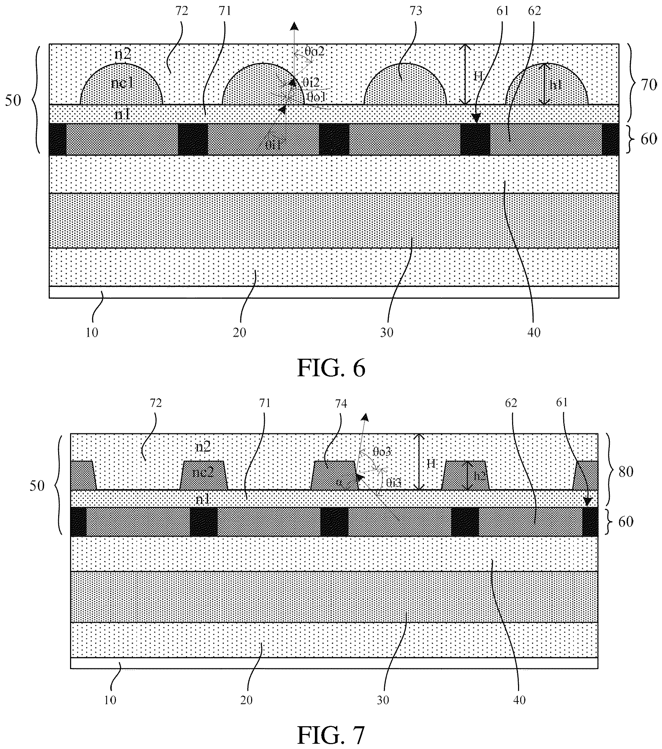

FIG. 6 is a schematic sectional view of a structure of a first display region according to an exemplary embodiment of the present disclosure, which is a cross-sectional view along the line A-A shown in FIG. 5, illustrating the structure of four sub-pixels. As shown in FIG. 6, on a plane perpendicular to the display substrate, the display substrate of the first display region may include a drive circuit layer 20 disposed on a base substrate 10, a light emitting structure layer 30 disposed on a side of the drive circuit layer 20 away from the base substrate, an encapsulation structure layer 40 disposed on a side of the light emitting structure layer 30 away from the base substrate, and a light-processing layer 50 disposed on a side of the encapsulation structure layer 40 away from the base substrate. The light-processing layer 50 may include a color filter structure layer 60 disposed on a side of the encapsulation structure layer 40 away from the base substrate and a first light extraction structure layer 70 disposed on a side of the color filter structure layer 60 away from the base substrate, forming a Color Filter on the Encapsulation (COE) layer structure.

In an exemplary embodiment, the drive circuit layer 20 may include plurality transistors and storage capacitors together forming a pixel drive circuit. The light emitting structure layer 30 may include a pixel define layer and a light emitting equipment, and the light emitting equipment may include an anode, an organic light emitting layer and a cathode. The encapsulation structure layer 40 may include a stacked first sub-layer, a second sub-layer and a third sub-layer, the first sub-layer and the third sub-layer may be made of inorganic materials, and the second sub-layer may be made of organic materials.

In an exemplary embodiment, the color filter structure layer 60 is configured to reduce the reflection of external light instead of a polarizer, so as to effectively improve the transmittance, color saturation and bending resistance of the display substrate. The first light extraction structure layer 70 is configured to perform light modulation to effectively improve the light output efficiency of the sub-pixels.

In an exemplary embodiment, the color filter structure layer 60 may at least include multiple black matrices 61 and multiple light filter layers 62. Multiple black matrices 61 and multiple light filter layers 62 may be disposed on a side of the encapsulation structure layer 40 away from the base substrate. Multiple black matrices 61 may be disposed at intervals, light-transmissive openings are formed between adjacent black matrices 61, and multiple light filter layers 62 may be disposed at intervals and respectively disposed in the multiple light-transmissive openings, forming an array of light filter layers separated by the black matrices 61, and the black matrices 61 is disposed between adjacent light filter layers 62.

In an exemplary embodiment, the multiple light filter layers 62 may include a red filter layer that transmits red light, a blue filter layer that transmits blue light, and a green filter layer that transmits green light. The red filter layer may be located in an region where the red sub-pixel (first sub-pixel P1) is located, the blue filter layer may be located in an region where the blue sub-pixel (second sub-pixel P2) is located, and the green filter layer may be located in an region where the green sub-pixel (third sub-pixel P3 and fourth sub-pixel P4) is located.

In an exemplary embodiment, the first light-taking structure layer 70 may at least include a first cover layer 71, a second cover layer 72, and multiple first light-taking structures 73. The first cover layer 71 may be provided on a side of the color filter structure layer 60 away from the base substrate and may cover the black matrix 61 and the multiple light filter layers 62. The multiple first light-taking structures 73 may be provided on a side of the first cover layer 71 away from the base substrate, and the positions of the multiple first light-taking structures 73 and the positions of the multiple light filter layers 62 may correspond one to one. The second cover layer 72 may be disposed on a side of the multiple first light-taking structures 73 away from the base substrate and may cover the multiple first light-taking structures 73.

In an exemplary embodiment, the surfaces of the first cover layer 71 and the second cover layer 72 on a side away from the base substrate may be planarized surfaces.

In an exemplary embodiment, an orthographic projection of the first light-taking structure 73 on the base substrate at least partially overlaps with an orthographic projection of the light filter layer 62 on the base substrate.

In an exemplary embodiment, the orthographic projection of the first light-taking structure 73 on the base substrate may be within the range of the orthographic projection of the light filter layer 62 on the base substrate.

In an exemplary embodiment, the orthographic projection of the first light-taking structure 73 on the base substrate and the orthographic projection of the light filter layer 62 on the base substrate may substantially coincide.

In an exemplary embodiment, the orthographic projection of the first light-taking structure 73 on the base substrate does not overlap with an orthographic projection of the black matrix 61 on the base substrate.

In an exemplary embodiment, the first light-taking structure 73 may be a spherical crown body. In a plane perpendicular to the base substrate, the cross-sectional shape of the first light-taking structure 73 may be a round crown shape. A plano-convex convex lens having a lower plane and a convex upper surface (i.e., a lower surface is flat and a convex upper surface) is formed, and is configured as a convex lens for converging light rays, so as to deflect the outgoing light rays of the sub-pixels in the direction of the center of the sub-pixels to improve the light output efficiency of the sub-pixels. In an exemplary embodiment, a center of the sub-pixel may be a geometric center of a sub-pixel.

In an exemplary embodiment, after the light emitted by the light emitting equipment in the light emitting structure layer 30 passes through the encapsulation structure layer 40, the light filter layer 62 and the first cover layer 71, the light is incident on the interface between the first cover layer 71 and the first light-taking structure 73 at a first incident angle $\theta i1$, and enters the first light-taking structure 73 at a first refraction angle $\theta o1$. After being transmitted in the first light-taking structure 73, the light is incident on the interface between the first light-taking structure 73 and the second cover layer 72 at a second incident angle $\theta i2$, and enters the second cover layer 72 at a second refraction angle $\theta o2$.

In an exemplary embodiment, the first cover layer 71 has a first refractive index n1, the second cover layer 72 has a second refractive index n2, and the first light-taking structure 73 has a first light-taking refractive index nc1, the first light-taking refractive index nc1 $\geq$ the first refractive index n1, and the first light-taking refractive index nc1 > the second refractive index n2.

In an exemplary embodiment, according to the refraction law $n1*Sin\Theta il = nc1*Sin\Theta ol$, it may be seen that since the first light-taking refractive index nc1 $\geq$ the first refractive index n1, the first incident angle $\theta i1$ of light rays incident on the first light-taking structure 73 is greater than or equal to the first refractive angle theta $\theta o1$ of light rays entering the first light-taking structure 73, that is, the light rays entering the first light-taking structure 73 are deflected in the direction of the center of the sub-pixel relative to the incident light rays. The greater the difference between the first refractive index n1 and the first light-taking refractive index nc1, the greater the degree of deflection of the light rays entering the first light-taking structure 73 toward the center of the sub-pixel.

In an exemplary embodiment, it may be seen from the refraction law $nc1*Sin\theta i2 = n2*Sin\theta o2$ that, since the first light-taking refractive index nc1 > the second refractive index n2, the second incident angle $\theta i2$ of light rays incident on the second cover layer 72 is less than the second refractive angle $\theta o2$ entering the second cover layer 72, that is, the light rays entering the second cover layer 72 are deflected in the direction of the center of the sub-pixel relative to the incident light rays. The greater the difference between the first light-taking refractive index nc1 and the second refractive index n2, the greater the degree of deflection of the light rays entering the second cover layer 72 toward the center of the sub-pixel.

In an exemplary embodiment, 1/3 < h1/H < 1/1.1.

Where H is the cover thickness of the second cover layer 72, and h1 is the first height of the first light-taking structure 73.

In an exemplary embodiment, the cover thickness H of the second cover layer 72 may be the maximum thickness of the second cover layer 72, and the cover thickness H may be the distance between the surface of the second cover layer 72 on a side away from the base substrate and the surface of the second cover layer 72 on a side close to the base substrate.

In an exemplary embodiment, the first height h1 of the first light-taking structure 73 may be a maximum height of the first light-taking structure 73, and the first height h1 may be a distance between a surface of the first light-taking structure 73 on a side away from the base substrate and a surface of the first light-taking structure 73 on a side close to the base substrate.

According to a display substrate provide by an exemplary embodiment of that present disclosure, by arranging a first light-taking structure layer including a first cover layer, a first light-taking structure and a second cover layer, the refractive index of the first light-taking structure is respectively greater than the refractive index of the first cover layer and the second cover layer. By using refraction, the emitted light is deflected toward the center of the sub-pixel, which can effectively improve the light emitting efficiency of the sub-pixel, improve the light emitting color gamut, and improve the display quality.

FIG. 7 is another schematic sectional view of a structure of a first display region according to an exemplary embodiment of the present disclosure, which is a cross-sectional view along the line A-A shown in FIG. 5, illustrating the structure of four sub-pixels. As shown in FIG. 7, on a plane perpendicular to the display substrate, the display substrate of the first display region may include a drive circuit layer 20 disposed on a base substrate 10, a light emitting structure layer 30 disposed on a side of the drive circuit layer 20 away from the base substrate, an encapsulation structure layer 40 disposed on a side of the light emitting structure layer 30 away from the base substrate, and a light-processing layer 50 disposed on a side of the encapsulation structure layer 40 away from the base substrate. The light-processing layer 50 may include a color filter structure layer 60 disposed on a side of the encapsulation structure layer 40 away from the base substrate and a second light extraction structure layer 80 disposed on a side of the color filter structure layer 60 away from the base substrate, forming a Color Filter on the Encapsulation (COE) layer structure.

In the exemplary embodiment, the structures of the drive circuit layer 20, the light emitting structure layer 30, the encapsulation structure layer 40, and the color filter structure layer 60 in the present exemplary embodiment are substantially the same as those of the embodiment shown in FIG. 6, and the second light-taking structure layer 80 is configured to perform light modulation to effectively improve the light emitting efficiency of the sub-pixels.

In an exemplary embodiment, the second light-taking structure layer 80 may at least include a first cover layer 71, a second cover layer 72, and multiple second light-taking structures 74. The first cover layer 71 may be provided on a side of the color filter structure layer 60 away from the base substrate and may cover the black matrix 61 and the multiple light filter layers 62. The multiple second light-taking structures 74 may be provided on a side of the first cover layer 71 away from the base substrate and the positions of the multiple second light-taking structures 74 may correspond to the positions of the multiple black matrices 61 one to one. The second cover layer 72 may be disposed on a side of the multiple second light-taking structures 74 away from the base substrate and may cover the multiple second light-taking structures 74.

In an exemplary embodiment, the surfaces of the first cover layer 71 and the second cover layer 72 on a side away from the base substrate may be planarized surfaces.

In an exemplary embodiment, the orthographic projection of the second light-taking structure 74 on the base substrate at least partially overlaps with an orthographic projection of the black matrix 61 on the base substrate.

In an exemplary embodiment, the orthographic projection of the black matrix 61 on the base substrate may be within the range of the orthographic projection of the second light-taking structure 74 on the base substrate.

In an exemplary embodiment, the orthographic projection of the second light-taking structure 74 on the base substrate at least partially overlaps with the orthographic projection of the light filter layer 62 on the base substrate.

In an exemplary embodiment, the second light-taking structure 74 may be a prism body, and in a plane perpendicular to the base substrate, the cross-sectional shape of the second light-taking structure 74 may be trapezoidal, and is configured to act as a prism concentrating light. A prism having a trapezoidal cross-section is formed, so as to deflect the outgoing light rays of the sub-pixels in the direction of the center of the sub-pixels to improve the light output efficiency of the sub-pixels.

In an exemplary embodiment, the trapezoidal cross-section of the second light-taking structure 74 may include an upper bottom, a lower bottom, and two sidewalls having a gradient angle $\alpha$, $60° < \alpha < 90°$.

In an exemplary embodiment, $1/3 < h2/H < 1/1.2$.

Where H is the cover thickness of the second cover layer 72, and h2 is the second height of the second light-taking structure 74. The second height h2 of the second light-taking structure 74 may be the maximum height of the second light-taking structure 74, that is, the distance between the surface of the second light-taking structure 74 on a side away from the base substrate and the surface of the second light-taking structure 74 on a side close to the base substrate.

In an exemplary embodiment, the second cover layer 72 has a second refractive index n2, the second light-taking structure 74 has a second light-taking refractive index nc2, the second light-taking refractive index nc2 < the second refractive index n2, and
the third incident angle $\theta i3$ > the critical angle of total reflection $\beta$, and the critical angle of total reflection $\beta$ = arcsin (nc2/n2).

In an exemplary embodiment, after the light emitted by the light emitting equipment in the light emitting structure layer 30 passes through the encapsulation structure layer 40, the light filter layer 62, the first cover layer 71 and the second cover layer 72, the light incident into the interface between the second cover layer 72 and the second light-taking structure 74 at a third incident angle $\theta i3$. Since the third incident angle $\theta i3$ is greater than the total reflection critical angle $\beta$, the incident light is totally reflected and re-enters the second cover layer 72 at the third reflection angle theta $\theta o3$, so that the light re-entering the second cover layer 72 is deflected in the direction of the center of the sub-pixel. The third incident angle $\theta i3$ = the third reflection angle theta $\theta o3$.

In an exemplary embodiment, the orthographic projection of at least one sub-pixel on the base substrate at least partially overlaps with the orthographic projection of two second light-taking structures 74 on the base substrate, and the gradient angles of the sidewalls of the two second light-taking structures 74 located within the region of the sub-pixel may be the same or may be different.

In an exemplary embodiment, the sidewalls of the two second light-taking structures 74 located in the region of the red sub-pixels have a first gradient angle α1, the sidewalls of the two second light-taking structures 74 located in the region of the blue sub-pixel have a second gradient angle α2, and the sidewalls of the two second light-taking structures 74 located in the region of the green sub-pixel have a third gradient angle α3, the first gradient angle α1 is less than the second gradient angle α2, and the first gradient angle α1 is less than the third gradient angle α3.

In an exemplary embodiment, the gradient angle of the sidewall of the second light-taking structure is related to the probability of total reflection of light, the greater the gradient angle, the less the probability of total reflection of light, and the less the gradient angle, the greater the probability of total reflection of light. The probability of total reflection of light is related to wavelength, the less the wavelength, the less the critical angle β of total reflection. Therefore, when the gradient angle of the sidewall of the second light-taking structure in the region where the red sub-pixel, the blue sub-pixel and the green sub-pixel are located is the same, the probability of total reflection of light in the blue sub-pixel is greater than that in the green sub-pixel, and the probability of total reflection of light in the green sub-pixel is greater than that in the red sub-pixel, thus causing the problem of bluing in a large viewing angle. By setting the gradient angle of the red sub-pixel less than that of other sub-pixels, the invention makes the probability of total reflection of light in the red sub-pixel greater than that of light in other sub-pixels, thereby effectively increasing red light, reducing green light and blue light, and effectively avoiding bluing in a large viewing angle.

According to a display substrate provide by an exemplary embodiment of that present disclosure, by arranging a second light-taking structure layer including a first cover layer, a second light-taking structure and a second cover layer, the refractive index of the second light-taking structure is less than the refractive index of the second cover layer. By using total refraction, the emitted light is deflected toward the center of the sub-pixel, which can effectively improve the light emitting efficiency of the sub-pixel, improve the light emitting color gamut, and improve the display quality.

According to the display substrate provide by an exemplary embodiment of the present disclosure, the gradient angle of the sidewall of the second light-taking structure in the region where the red sub-pixel is located is configured to be less than the gradient angle of the sidewall of the second light-taking structure in the region where the other sub-pixels are located, so that red light may be effectively increased, green light and blue light may be reduced, and bluing in a large viewing angle may be effectively avoided.

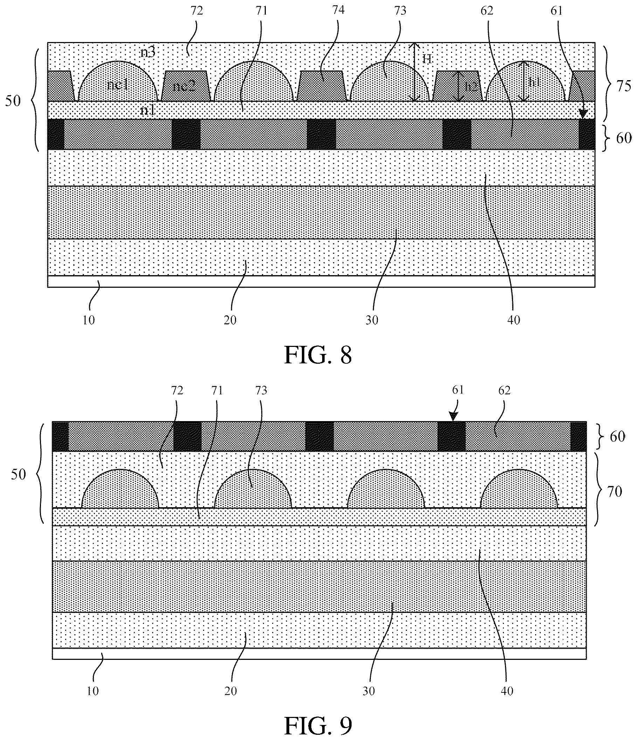

FIG. 8 is another schematic sectional view of a structure of a first display region according to an exemplary embodiment of the present disclosure, which is a cross-sectional view along the line A-A shown in FIG. 5, illustrating the structure of four sub-pixels. As shown in FIG. 8, on a plane perpendicular to the display substrate, the display substrate of the first display region may include a drive circuit layer 20 disposed on a base substrate 10, a light emitting structure layer 30 disposed on a side of the drive circuit layer 20 away from the base substrate, an encapsulation structure layer 40 disposed on a side of the light emitting structure layer 30 away from the base substrate, and a light-processing layer 50 disposed on a side of the encapsulation structure layer 40 away from the base substrate. The light-processing layer 50 may include a color filter structure layer 60 disposed on a side of the encapsulation structure layer 40 away from the base substrate and a composite light extraction structure layer 75 disposed on a side of the color filter structure layer 60 away from the base substrate, forming a Color Filter on the Encapsulation (COE) layer structure.

In the exemplary embodiment, the structures of the drive circuit layer 20, the light emitting structure layer 30, the encapsulation structure layer 40, and the color filter structure layer 60 in the present exemplary embodiment are substantially the same as those of the embodiment shown in FIG. 6, and the composite light-taking structure layer 75 is configured to perform light modulation to effectively improve the light emitting efficiency of the sub-pixels.

In an exemplary embodiment, the composite light-taking structure layer 75 may at least include a first cover layer 71, a second cover layer 72, multiple first light-taking structures 73, and multiple second light-taking structures 74. The first cover layer 71 may be provided on a side of the color filter structure layer 60 away from the base substrate and may cover the black matrix 61 and the multiple light filter layers 62. Multiple first light-taking structures 73 and multiple second light-taking structures 74 may be disposed on a side of the first cover layer 71 away from the base substrate. The first light-taking structures 73 and the second light-taking structures 74 may be alternately arranged. The positions of the multiple first light-taking structures 73 may correspond one-to-one with the positions of the multiple light filter layers 62, and the positions of the multiple second light-taking structures 74 may correspond one-to-one with the positions of the multiple black matrices 61. The second cover layer 72 may be disposed on a side of the multiple first light-taking structures 73 and the multiple second light-taking structures 74 away from the base substrate, and the second cover layer 72 may cover the multiple first light-taking structures 73 and the multiple second light-taking structures 74.

In an exemplary embodiment, the surfaces of the first cover layer 71 and the second cover layer 72 on a side away from the base substrate may be planarized surfaces.

In an exemplary embodiment, the orthographic projection of the first light-taking structure 73 on the base substrate may be within the range of the orthographic projection of the light filter layer 62 on the base substrate, and the orthographic projection of the first light-taking structure 73 on the base substrate does not overlap with an orthographic projection of the black matrix 61 on the base substrate.

In an exemplary embodiment, the orthographic projection of the black matrix 61 on the base substrate may be within the range of the orthographic projection of the second light-taking structure 74 on the base substrate, and the orthographic projection of the second light-taking structure 74 on the base substrate at least partially overlaps with the orthographic projection of the two light filter layers 62 on the base substrate.

In an exemplary embodiment, the first light-taking structure 73 may be a spherical crown body configured as a convex lens for converging light rays, and the second light-taking structure 74 may be a prism body configured as a prism for converging light rays. The first light-taking structure 73 and the second light-taking structure 74 of the present exemplary embodiment may be substantially the same as the light-taking structures of the foregoing embodiments and will not be described here.

In an exemplary embodiment, the first light-taking refractive index nc1 is $\geq$ the first refractive index n1, the first light-taking refractive index nc1 is > the second refractive index n2, and the second light-taking refractive index nc2 is < the second refractive index n2.

In exemplary embodiments, 1/3 < h1/H < 1/1.1, 1/3 < h2/H < 1/1.2.

According to a display substrate provide by an exemplary embodiment of the present disclosure, by arranging a composite light-taking structure layer including a first cover layer, a first light-taking structure, a second light-taking structure and a second cover layer, and by using refraction and total reflection to deflect the outgoing light towards the center of the sub-pixel, the outgoing light efficiency of the sub-pixel may be maximized, the outgoing light gamut may be improved, the bluing in large viewing angle may be effectively avoided, and the display quality may be improved.

FIG. 9 is another schematic sectional view of a structure of a first display region according to an exemplary embodiment of the present disclosure, which is a cross-sectional view along the line A-A shown in FIG. 5, illustrating the structure of four sub-pixels. As shown in FIG. 9, the body structure of the display substrate of the present exemplary embodiment is substantially the same as that of the display substrate shown in FIG. 6, except that the first light-taking structure layer 70 in the light-processing layer 50 is disposed on a side of the encapsulation structure layer 40 away from the base substrate, and the color filter structure layer 60 is disposed on a side of the first light-taking structure layer 70 away from the base substrate.

In an exemplary embodiment, the first light-taking structure 73 may be a spherical crown body configured as a convex lens for converging light rays, and the structure and parameters of the first light-taking structure 73 of the present exemplary embodiment may be substantially the same as those of the first light-taking structure 73 shown in FIG. 6, which will not be described here.

According to the display substrate provide by an exemplary embodiment of that present disclosure, it can not only effectively improve the light emitting efficiency of sub-pixels, improve the light emitting color gamut and improve the display quality; moreover, by arranging the first light-taking structure layer close to the base substrate, the light emitted from the display structure layer is modulated before entering the color filter structure layer, which can improve the efficiency of modulating the light and further improve the light emitting efficiency of sub-pixels.

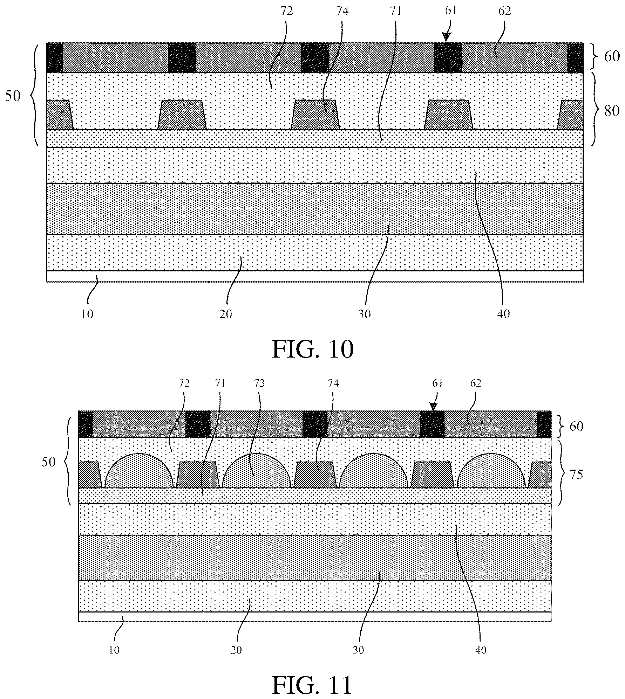

FIG. 10 is another schematic sectional view of a structure of a first display region according to an exemplary embodiment of the present disclosure, which is a cross-sectional view along the line A-A shown in FIG. 5, illustrating the structure of four sub-pixels. As shown in FIG. 10, the body structure of the display substrate of the present exemplary embodiment is substantially the same as that of the display substrate shown in FIG. 7, except that the second light-taking structure layer 80 in the light-processing layer 50 is disposed on a side of the encapsulation structure layer 40 away from the base substrate, and the color filter structure layer 60 is disposed on a side of the second light-taking structure layer 80 away from the base substrate.

In the exemplary embodiment, the second light-taking structure 74 may be a prism body configured as a prism for converging light rays, and the structure and parameters of the second light-taking structure 74 of the present exemplary embodiment may be substantially the same as those of the second light-taking structure 74 shown in FIG. 7, and will not be described here.

According to the display substrate provide by an exemplary embodiment of that present disclosure, it can not only effectively improve the light emitting efficiency of sub-pixels, improve the light emitting color gamut and improve the display quality; moreover, by arranging the second light-taking structure layer close to the base substrate, the light emitted from the display structure layer is modulated before entering the color filter structure layer, which can improve the efficiency of modulating the light and further improve the light emitting efficiency of sub-pixels.

FIG. 11 is another schematic sectional view of a structure of a first display region according to an exemplary embodiment of the present disclosure, which is a cross-sectional view along the line A-A shown in FIG. 5, illustrating the structure of four sub-pixels. As shown in FIG. 11, the body structure of the display substrate of the present exemplary embodiment is substantially the same as that of the display substrate shown in FIG. 8, except that the composite light-taking structure layer 75 in the light-processing layer 50 is disposed on a side of the encapsulation structure layer 40 away from the base substrate, and the color filter structure layer 60 is disposed on a side of the composite light-taking structure layer 75 away from the base substrate.

In an exemplary embodiment, the first light-taking structure 73 may be a spherical crown body configured as a convex lens for converging light rays, and the second light-taking structure 74 may be a prism body configured as a prism for converging light rays. The structures and parameters of the first light-taking structure 73 and the second light-taking structure 74 of the present exemplary embodiment may be substantially the same as those of the first light-taking structure 73 and the second light-taking structure 74 in the foregoing embodiments, and will not be described here.

According to the display substrate provide by an exemplary embodiment of that present disclosure, it can not only effectively improve the light emitting efficiency of sub-pixels, improve the light emitting color gamut and improve the display quality; moreover, by arranging the composite light-taking structure layer close to the base substrate, the light emitted from the display structure layer is modulated before entering the color filter structure layer, which can improve the efficiency of modulating the light and further improve the light emitting efficiency of sub-pixels.

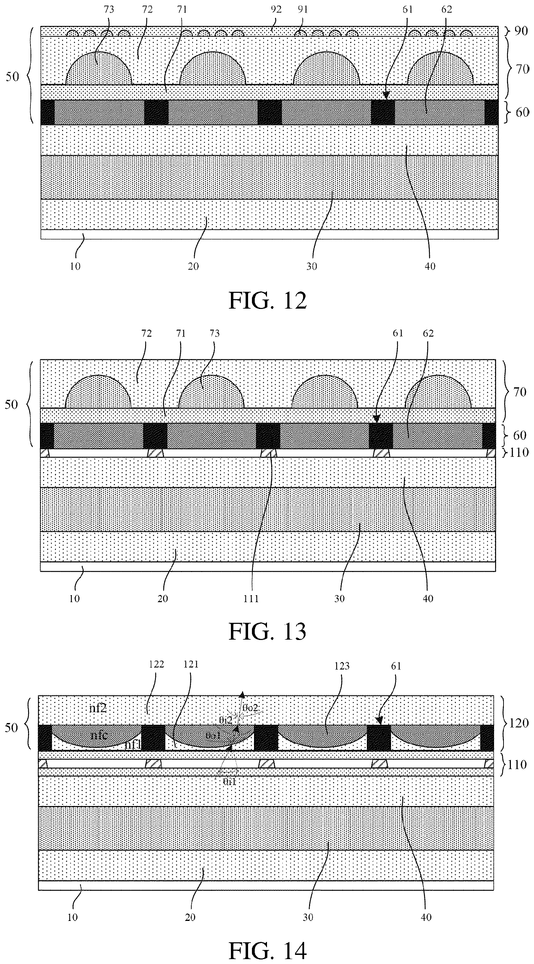

FIG. 12 is another schematic sectional view of a structure of a first display region according to an exemplary embodiment of the present disclosure, which is a cross-sectional view along the line A-A shown in FIG. 5, illustrating the structure of four sub-pixels. As shown in FIG. 12, a main body structure of the display substrate of the present exemplary embodiment is substantially the same as the main body structure of the display substrate shown in FIG. 6. The difference is that the light-processing layer 50 of the present exemplary embodiment may further include a third light-taking structure layer 90, the color filter structure layer 60 is disposed on a side of the encapsulation structure layer 40 away from the base substrate, the first light-taking structure layer 70 is disposed on a side of the color filter structure layer 60 away from the base substrate, and the third light-taking structure layer 90 is disposed on a side of the first light-taking structure layer 70 away from the base substrate.

In an exemplary embodiment, the third light-taking structure layer 90 may at least include multiple third light-taking structures 91 and a third cover layer 92. The multiple third light-taking structures 91 may be disposed on a side of the second cover layer 72 away from the base substrate, the third cover layer 92 may be disposed on a side of the multiple third light-taking structures 91 away from the base substrate, and the third cover layer 92 may cover the multiple third light-taking structures 91.

In an exemplary embodiment, the surface of the third cover layer 92 on a side away from the base substrate may be a planarized surface.

In an exemplary embodiment, the third light-taking structure 91 may be a microlens group, which may include multiple sequentially arranged microlenses configured to perform light modulation to effectively improve the light output efficiency of the sub-pixels.

In an exemplary embodiment, the orthographic projection of the third light-taking structure 91 on the base substrate at least partially overlaps with the orthographic projection of the first light-taking structure 73 on the base substrate.

In an exemplary embodiment, the orthographic projection of the third light-taking structure 91 on the base substrate may be within the range of the orthographic projection of the light filter layer 62 on the base substrate.

According to the display substrate provide by an exemplary embodiment of that present disclosure, it can not only effectively improve the light emitting efficiency of sub-pixels, improve the light emitting color gamut and improve the display quality; moreover, by arranging the third light-taking structure, the invention can further improve the light emitting efficiency of sub-pixels, further improve the light emitting color gamut and further improve the display quality.

In one possible exemplary embodiment, a third light-taking structure layer may be provided in the structure shown in FIG. 8, and the third light-taking structure layer may be provided on a side of the composite light-taking structure layer away from the base substrate.

In one possible exemplary embodiment, a third light-taking structure layer may be provided in the structures shown in FIGS. 9 and 11, and the third light-taking structure layer may be provided on a side of the color filter structure layer away from the base substrate.

FIG. 13 is another schematic sectional view of a structure of a first display region according to an exemplary embodiment of the present disclosure, which is a cross-sectional view along the line A-A shown in FIG. 5, illustrating the structure of four sub-pixels. As shown in FIG. 13, a main body structure of the display substrate of the present exemplary embodiment is substantially the same as the main body structure of the display substrate shown in FIG. 6. A difference is that the display substrate of this exemplary embodiment may further includes a touch control structure layer 110.

In an exemplary embodiment, the touch control structure layer 110 may be disposed on a side of the encapsulation structure layer 40 away from the base substrate, and the color filter structure layer 60 may be disposed on a side of the touch control structure layer 110 away from the base substrate.

In an exemplary embodiment, on a plane perpendicular to the base substrate, the touch control structure layer 110 may at least include a metal grid layer in the form of a metal grid, which includes multiple metal wires 111 interwoven with each other, and the multiple metal wires 111 enclosing a grid pattern. On a plane parallel to the base substrate, the shape of the grid pattern may include any one or more of the following: triangle, square, rectangle, rhombus, trapezoid, pentagon and hexagon.

In an exemplary embodiment, the orthographic projection of the metal wire 111 on the base substrate at least partially overlaps the orthographic projection of the black matrix 61 on the base substrate.

In an exemplary embodiment, the orthographic projection of the metal wire 111 on the base substrate may be within at least a range of the orthographic projection of the black matrix 61 on the base substrate, and the metal wire 111 may be shielded by the black matrix 61 to avoid reflection of the metal wire 111.

In an exemplary embodiment, the touch control structure layer 110 may be a Flexible Single Layer On Cell (FSLOC) structure, and the touch control structure layer 110 may include a first touch insulation layer, a metal grid layer, and a second touch insulation layer. The first touch insulation layer may be located on a side of the metal grid layer close to the base substrate, and the second touch insulation layer may be located on a side of the metal grid layer away from the base substrate.

In an exemplary embodiment, the touch control structure layer 110 may be a Flexible Multi Layer On Cell (FMLOC) structure, the touch control structure layer 110 may include a first touch insulation layer, a first metal grid layer, a second touch insulation layer, a second metal grid layer, and a third touch insulation layer. The first touch insulation layer may be located on a side of the first metal grid layer close to the base substrate, the second touch insulation layer may be located on a side of the first metal grid layer away from the base substrate, the second metal grid layer may be located on a side of the second touch insulation layer away from the base substrate, and the third touch insulation layer may be located on a side of the second metal grid layer away from the base substrate.

According to the display substrate provide by an exemplary embodiment of that present disclosure, it can not only effectively improve the light emitting efficiency of sub-pixels, improve the light emitting color gamut and improve the display quality; moreover, it can effectively avoid the reflection of the metal wires and improve the display quality by shielding the metal wires in the touch control structure layer by using a black matrix.

In an exemplary embodiment, in the structures shown in FIGS. 7 to 11, the touch control structure layer may be provided, and the touch control structure layer is provided on a side of the color filter structure layer close to the base substrate, which can achieve the technical effects of avoiding the reflection of metal wires and improving the display quality, and will not be described here.

FIG. 14 is another schematic sectional view of a structure of a first display region according to an exemplary embodiment of the present disclosure, which is a cross-sectional view along the line A-A shown in FIG. 5, illustrating the structure of four sub-pixels. As shown in FIG. 14, on a plane perpendicular to the display substrate, the display substrate of the first display region may include a drive circuit layer 20 disposed on a base substrate 10, a light emitting structure layer 30 disposed on a side of the drive circuit layer 20 away from the base substrate, an encapsulation structure layer 40 disposed on a side of the light emitting structure layer 30 away from the base substrate, a touch control structure layer 110 disposed on a side of the encapsulation structure layer 40 away from the base substrate, and a light-processing layer 50 disposed on a side of the touch control structure layer 110 away from the base substrate. The light-processing layer 50 may include a color filter lens structure layer 120 disposed on a side of the encapsulation structure layer 40 away from the base substrate, forming Color filter On Encapsulation (COE for short) structure.

In an exemplary embodiment, the structures of the drive circuit layer 20, the light emitting structure layer 30 and the encapsulation structure layer 40 in the present exemplary embodiment are substantially the same as those of the embodiment shown in FIG. 6. On the one hand, the color filter lens structure layer 120 is configured to reduce the reflection of external light and replace polarizers to effectively improve the transmittance and color saturation of the display substrate and improve the bending resistance of the display substrate; on the other hand, it is configured to perform light modulation to effectively improve the light outgoing efficiency of sub-pixels.

In an exemplary embodiment, the touch control structure layer 110 may include a first touch insulation layer, a metal grid layer, and a second touch insulation layer. The first touch insulation layer may be disposed on a side of the encapsulation structure layer 40 away from the base substrate, the metal grid layer may be disposed on a side of the first touch insulation layer away from the base substrate, and the second touch insulation layer may be disposed on a side of the metal grid layer away from the base substrate. The orthographic projection of the metal wire in the metal grid layer on the base substrate may be within at least a range of the orthographic projection of the black matrix on the base substrate.

In an exemplary embodiment, the color filter lens structure layer 120 may at least include a black matrix 61, a first color filter layer 121, a second color filter layer 122, and multiple light filter lens layers 123.

In an exemplary embodiment, multiple black matrices 61 may be disposed on a side of the touch control structure layer 110 away from the base substrate and may be disposed at intervals. Light-transmissive openings are formed between adjacent black matrices 61.

In an exemplary embodiment, the multiple first color filter layers 121 may be disposed at intervals and respectively disposed on the touch control structure layer 110 within the multiple light-transmissive openings. The shape of the first color filter layer 121 may be a cylindrical structure and an upper surface (a surface away from the base substrate) of the first color filter layer 121 is provided with an arc-shaped concave.

In an exemplary embodiment, the multiple light filter lens layers 123 may be disposed at intervals and respectively disposed on the first color filter layer 121 within the multiple light-transmissive openings. The light filter lens layer 123 may be a spherical crown body, forming a plano-convex lens with upper plane and lower convex (that is, the upper surface is flat and the lower surface is convex). An arcuate convex lower surface (a surface near the base substrate) of the light filter lens layer 123 is closely attached to an arcuate concave upper surface (a surface away from the base substrate) of the first color filter layer 121 to form a filtering and light-taking multiplex structure integrating a filter structure and a light-taking structure. The light filter lens layer 123 is configured as a lens for converging light rays.

In an exemplary embodiment, the second color filter layer 122 may be disposed on a side of the multiple black matrices 61 and the multiple light filter lens layers 123 away from the base substrate, and the second color filter layer 122 may cover the multiple black matrices 61 and the multiple light filter lens layers 123.

In an exemplary embodiment, the surface of the second color filter layer 122 on a side away from the base substrate may be a planarized surface.

In an exemplary embodiment, after the light emitted by the light emitting equipment in the light emitting structure layer 30 passes through the encapsulation structure layer 40, the touch control structure layer 110 and the first color filter layer 121, the light is incident on the interface between the first color filter layer 121 and the light filter lens layer 123 at a first incident angle $\theta i1$ and enters the light filter lens layer 123 at a first refraction angle $\theta o1$. After being transmitted in the light filter lens layer 123, the light is incident on the interface between the light filter lens layer 123 and the second color filter layer 122 at a second incident angle $\theta i2$ and enters the second color filter layer 122 at a second refraction angle $\theta o2$.

In an exemplary embodiment, the first color filter layer 121 has a first color filter refractive index nf1, the second color filter layer 122 has a second color filter refractive index nf2, and the light filter lens layer 123 has a filter lens refractive index ncf, the filter lens refractive index ncf > the first color filter refractive index nf1, and the filter lens refractive index ncf < the second color filter refractive index nf2.

In an exemplary embodiment, it may be seen from the refraction law nf1 $*Sin\theta i1= ncf*Sin\theta o1$ that, since the filter lens refractive index ncf > the first color filter refractive index nf1, the first incident angle $\theta i1$ of light rays incident on the light filter lens layer 123 is greater than the first refractive angle $\theta o1$ of light rays entering the light filter lens layer 123, that is, the light rays entering the light filter lens layer 123 are deflected in the direction of the center of the sub-pixel relative to the incident light rays.

In an exemplary embodiment, it may be seen from the refraction law ncf$*Sin\theta i2=nf2*Sin\theta o2$ that, since the refractive index ncf of the filter lens < the refractive index nf2 of the second color filter layer 122, the second incident angle $\theta i2$ of light rays incident on the second color filter layer 122 is greater than the second refractive angle $\theta o2$ entering the second color filter layer 122, that is, the light rays entering the second color filter layer 122 are deflected in the direction of the center of the sub-pixel relative to the incident light rays.

In the display substrate provided by the exemplary embodiment of the present disclosure, by setting up a filter and light-taking multiplexing structure for multiplexing the light filtering structure and the light-taking structure, it not only can effectively improve the light output efficiency of sub-pixels, improve the light color gamut and the display quality, but also can effectively reduce the thickness of a display substrate, which is beneficial to achieving an ultra-thin display apparatus.

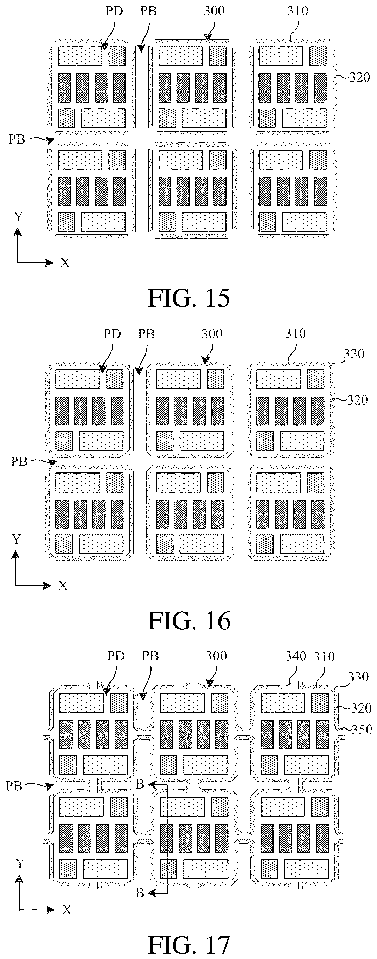

FIG. 15 is another schematic plan view of a structure of a first display region according to an exemplary embodiment of the present disclosure. A main body structure of the display substrate of the present exemplary embodiment is substantially the same as the main body structure of the display substrate shown in FIG. 5. The difference is that, in this exemplary embodiment, the first display region of the display substrate is also provided with a light-scattering structure. As shown in FIG. 15, the first display region may include multiple pixel islands PD and blank islands PB. In the first direction X, pixel islands PD and blank islands PB are alternately arranged, and in the second direction Y, pixel islands PD and blank islands PB are alternately arranged, so that blank islands PB are provided between adjacent pixel islands PD in the first direction X and between adjacent pixel islands PD in the second direction Y. The blank islands PB form a space between pixel islands PD, and at least one blank island PB is provided with an light-scattering structure 300.

In an exemplary embodiment, at least one light-scattering structure 300 may be disposed within the blank island PB and at least one side of the pixel island PD, and the light-scattering structure 300 is configured to increase scattering at the edge of the pixel island PD to reduce a display difference between the first display region and the second display region.

In an exemplary embodiment, at least one light-scattering structure 300 may include two first light-scattering strips 310 and two second light-scattering strips 320. The shape of the first light-scattering strips 310 may be a strip shape extending along the first direction X and may be provided on both sides of the pixel island PD in the second direction Y, respectively, and the two first light-scattering strips 310 are disposed opposite to each other. The shape of the second light-scattering strips 320 may be a strip shape extending along the second direction Y, and may be respectively provided on both sides of the first direction X of the pixel island PD, and the two second light-scattering strips 320 are opposite to each other.

In an exemplary embodiment, the first light-scattering strip 310 and the second light-scattering strip 320 may include multiple micro-protrusions arranged in sequence. In a plane parallel to the base substrate, the shape of the micro-protrusions may include any one or more of the following: triangle, rectangle, pentagon, hexagon, circle and ellipse.

In a plane perpendicular to the base substrate, the cross-sectional shape of the micro-protrusions may include triangles or trapezoids.

In an exemplary embodiment, the micro-protrusions may be made of a metallic material and may be disposed in corresponding conductive layers in the drive circuit layer and formed synchronously with the corresponding conductive layers by the same one-time patterning process.

FIG. 16 is another schematic plan view of a structure of a first display region according to an exemplary embodiment of the present disclosure. A main body structure of the display substrate of the present exemplary embodiment is substantially the same as the main body structure of the display substrate shown in FIG. 15. The difference is that the light-scattering structure 300 in this exemplary embodiment is in the shape of a ring surrounding the pixel island PD.

As shown in FIG. 16, in an exemplary embodiment, at least one light-scattering structure 300 further includes a third light-scattering strip 320 respectively connected to the first light-scattering strip 310 and the second light-scattering strip 320, and the first, second and third light-scattering strips 310, 320 and 320 are sequentially connected to form a ring-shaped light-scattering structure 300 surrounding the pixel island PD.

In an exemplary embodiment, the first light-scattering strip 310, the second light-scattering strip 320, and the third light-scattering strip 320 may include multiple micro-protrusions arranged in sequence.

FIG. 17 is another schematic plan view of a structure of a first display region according to an exemplary embodiment of the present disclosure. A main body structure of the display substrate of the present exemplary embodiment is substantially the same as the main body structure of the display substrate shown in FIG. 16. The difference is that in this exemplary embodiment, connection strips are provided between adjacent light-scattering structures 300.

As shown in FIG. 17, in an exemplary embodiment, the light-scattering structure 300 of the present exemplary embodiment may include a first light-scattering strip 310, a second light-scattering strip 320, a third light-scattering strip 320, a first connection strip 340, and a second connection strip 350. The first light-scattering strip 310, the second light-scattering strip 320, and the third light-scattering strip 320 are sequentially connected to form a sub-light-scattering structure surrounding one pixel island PD. A first connection strip 340 is provided between adjacent sub-light-scattering structures in the second direction Y. The first connection strip 340 is respectively connected to the first light-scattering strips 310 of the sub-light-scattering structures adjacent to the second direction Y and the first light-scattering strip 310 of the sub-light-scattering structure adjacent to the opposite direction of the second direction Y. A connection channel is formed between the sub-light-scattering structures adjacent to the second direction Y, so that the sub-light-scattering structures adjacent to the second direction Y are communicated with each other. A second connection strip 350 is provided between adjacent sub-light-scattering structures in the first direction X. The second connection strip 350 is respectively connected to the second light-scattering strips 320 of the sub-light-scattering structures adjacent to the first direction X and the second light-scattering strips 320 of the sub-light-scattering structures adjacent to the opposite direction of the first direction X. A connection channel is formed between the sub-light-scattering structures adjacent to the first direction X, so that the sub-light-scattering structures adjacent to the first direction X are communicated with each other. In this way, the light-scattering structure 300 surrounding the pixel islands PD and communicating with each other is formed.

In an exemplary embodiment, a first signal connection line extending along the first direction X is provided between pixel islands PD adjacent to the first direction X, and the first signal connection line is configured to respectively connect pixel drive circuits in the two pixel islands PD to achieve mutual connection of multiple pixel drive circuits. An orthographic projection of the second connection strip 350 on the base substrate at least partially overlaps an orthographic projection of the first signal connection line on the base substrate.

In an exemplary embodiment, the orthographic projection of the first signal connection line on the base substrate may be within the range of the orthographic projection of the second connection strip 350 on the base substrate.

In an exemplary embodiment, a second signal connection line extending along the second direction Y is provided between pixel islands PD adjacent to each other in the second direction Y, and the second signal connection line is configured to respectively connect pixel drive circuits in the two pixel islands PD to achieve mutual connection of multiple pixel drive circuits. An orthographic projection of the first connection strip 340 on the base substrate at least partially overlaps an orthographic projection of the second signal connection line on the base substrate.

In an exemplary embodiment, the orthographic projection of the second signal connection line on the base substrate may be within the range of the orthographic projection of the first connection strip 340 on the base substrate.

The display substrate provided by the exemplary embodiment of the present disclosure can not only achieve the technical effect of the foregoing embodiment; moreover, by setting the light-scattering structure, the invention can effectively increase the scattering of the edge of the pixel island and the region where the signal connection line is located, and effectively reduce the display difference between the first display region and the second display region.

Exemplary description is made below through a preparation process of a display substrate. A "patterning process" mentioned in the present disclosure includes coating with a photoresist, mask exposure, development, etching, photoresist stripping, and other treatments for a metal material, an inorganic material, or a transparent conductive material, and includes coating with an organic material, mask exposure, development, and other treatments for an organic material. Deposition may be any one or more of sputtering, evaporation, and chemical vapor deposition. Coating may be any one or more of spray coating, spin coating, and ink-jet printing. Etching may be any one or more of dry etching and wet etching, which is not limited in present disclosure. A "thin film" refers to a layer of thin film made of a material on a base substrate through a process such as deposition, coating, etc. If the "thin film" does not need a patterning process in an entire preparation process, the "thin film" may also be called a "layer". If the "thin film" needs a patterning process in an entire preparation process, it is called a "thin film" before the patterning process, and called a "layer" after the patterning process. The "layer" after the patterning process at least includes one "pattern". "A and B being disposed on a same layer" mentioned in the present disclosure means that A and B are formed simultaneously through a same patterning process, and a "thickness" of a film layer is a dimension of the film layer in a direction perpendicular to a display substrate. In an exemplary embodiment of the present disclosure, "an orthographic projection of B is within a range of an orthographic projection of A" or "an orthographic projection of A includes an orthographic projection of B" refers to that a boundary of the orthographic projection of B falls within a range of a boundary of the orthographic projection of A, or the boundary of the orthographic projection of A is overlapped with the boundary of the orthographic projection of B.

In an exemplary embodiment, taking three sub-pixels in the first display region as an example, the preparation process of the display substrate may include the following steps:

(1) A pattern of a drive circuit layer is formed. In an exemplary implementation mode, forming the pattern of the drive circuit layer may include following operations.

a first insulation thin film and a semiconductor thin film are sequentially deposited on the base substrate 10, the semiconductor thin film is patterned through a patterning process to form a first insulation layer covering the base substrate and a pattern of a semiconductor layer disposed on the first insulation layer. The pattern of the semiconductor layer of each sub-pixel may at least include multiple active layers.

Subsequently, a second insulation thin film and a first conductive thin film are sequentially deposited, and the first conductive thin film is patterned through a patterning process to form a second insulation layer covering the pattern of the semiconductor layer and a pattern of a first conductive layer disposed on the second insulation layer. The pattern of the first conductive layer of each sub-pixel may at least include multiple gate electrodes and a first electrode plate.

Subsequently, a third insulation thin film and a second conductive thin film are sequentially deposited, and the second conductive thin film is patterned through a patterning process to form a third insulation layer covering the first conductive layer, and a pattern of a second conductive layer disposed on the third insulation layer. The pattern of the second conductive layer in each of the sub-pixel may at least include: a second electrode plate, an orthographic projection of the second electrode plate on the base substrate and an orthographic projection of the first electrode plate on the base substrate are at least partially overlapped.

Subsequently, a fourth insulation thin film is deposited, and the fourth insulation thin film is patterned through a patterning process to form a pattern of the fourth insulation layer covering the pattern of the second conductive layer. Two active via holes are formed on the fourth insulation layer of each sub-pixel, and the two active via holes respectively expose two terminals of the active layer.

Subsequently, a third conductive thin film is deposited, the third conductive thin film is patterned through a patterning process to form a pattern of the third conductive layer on the fourth insulation layer. The pattern of the third conductive layer at least includes: a source electrode and a drain electrode located in each sub-pixel, and a light-scattering structure 300 located outside the pixel unit. The source electrode and the drain electrode are respectively connected to the active layer through active via holes.

In an exemplary embodiment, the light-scattering structure 300 may include multiple sequentially arranged micro-protrusions, the shape of which includes any one or more of triangular, rectangular, pentagonal, hexagonal, circular and elliptical in a plane parallel to the base substrate. The cross-sectional shape of the micro-protrusion 300A includes triangular, rectangular or trapezoidal in a plane perpendicular to the base substrate.

Subsequently, a planarization thin film is coated on the base substrate on which the aforementioned patterns are formed, and the planarization thin film is patterned through a patterning process to form a pattern of a planarization layer covering the pattern of the third conductive layer. At least one connection via hole is formed on the planarization layer of each sub-pixel, and the connection via hole exposes the surface of the drain electrode.

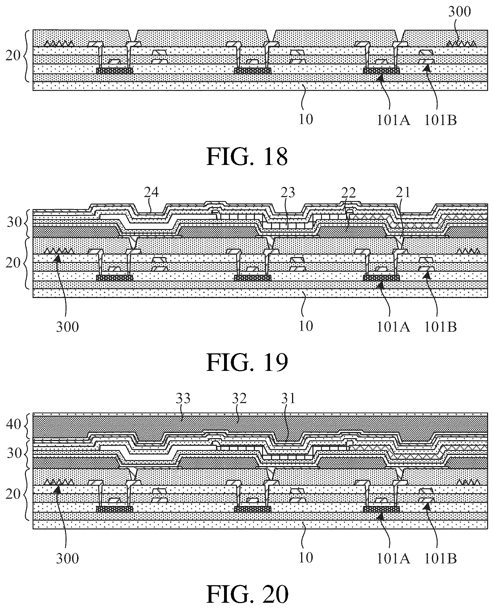

At this point, the pattern of the drive circuit layer 20 is prepared, as shown in FIG. 18, which is a cross-sectional view along B-B in FIG. 17. In an exemplary embodiment, the drive circuit layer 20 of each sub-pixel may include multiple transistors and a storage capacitor that form a pixel drive circuit. In FIG. 18, for example, the pixel drive circuit includes one transistor 101A and a storage capacitor 101B.

In an exemplary implementation mode, the transistor 101A may include an active layer, a gate electrode, a source electrode, and a drain electrode, and the storage capacitor 101B may include a first electrode plate and a second electrode plate. In an exemplary implementation mode, a transistor 101A may be a drive transistor in a pixel drive circuit.

The drive transistor may be a Thin Film Transistor (TFT).

In an exemplary embodiment, the light-scattering structure may be disposed in the first conductive layer, or the light-scattering structure may be disposed in the second conductive layer, or the light-scattering structure may be disposed in any one or more of the first conductive layer, the second conductive layer, and the third conductive layer, and the present disclosure is not limited herein.

In an exemplary implementation mode, a base substrate may be a flexible base substrate, or may be a rigid base substrate. The rigid base substrate may be made of a material such as glass or quartz, the flexible base substrate may be made of a material such as Polyimide (PI), the flexible base substrate may be of a single-layer structure, or may be a laminated structure composed of an inorganic material layer and a flexible material layer, and the present disclosure is not limited herein.

In an exemplary implementation mode, the first insulation layer, the second insulation layer, the third insulation layer, and the fourth insulation layer may be made of any one or more of Silicon Oxide (SiOx), Silicon Nitride (SiNx), and Silicon Oxynitride (SiON), and may be a single layer, a multi-layer, or a composite layer. The first insulation layer may be referred to as a Buffer layer, the second insulation layer and the third insulation layer may be referred to as Gate insulator (GI) layers, and the fourth insulation layer may be referred to as an Interlayer Dielectric (ILD) layer. The first conductive layer, the second conductive layer, and the third second conductive layer may be made of a metal material, such as any one or more of Argentum (Ag), Copper (Cu), Aluminum (Al), Titanium (Ti), and Molybdenum (Mo), or an alloy material of the above metals, such as an Aluminum Neodymium alloy (AlNd) or a Molybdenum Niobium alloy (MoNb), and may be of a single-layer structure, or a multi-layer composite structure, such as Ti/Al/Ti. The planarization thin film may be made of an organic material such as resin. The active layer may be made of various materials, such as amorphous indium gallium zinc oxide ($\alpha$-IGZO), zinc oxynitride (ZnON), indium zinc tin oxide (IZTO), amorphous silicon ($\alpha$-Si), polycrystalline silicon (p-Si), hexathiophene and polythiophene. That is, the present disclosure is applicable to transistors manufactured based on oxide technology, silicon technology, and organic substance technology and the present disclosure is not limited herein.

(2) A pattern of a light emitting structure layer is formed. In an exemplary embodiment, the formation of the pattern of the light emitting structure layer may include the following operations.

A fourth conductive thin film is deposited on the base substrate on which the aforementioned patterns are formed, the fourth conductive thin film is patterned through a patterning process to form a pattern of an anode electrode layer. The pattern of the anode electrode layer of each sub-pixel may at least include an anode 21, and the anode 21 is connected to the drain electrode of the transistor 101A through a connection via hole.

Subsequently, a pixel define thin film is coated base on the base substrate on which the aforementioned patterns are formed, and the pixel define thin film is patterned through a patterning process to form a pixel define layer 22. The pixel define layer of each sub-pixel is provided with a pixel opening, and the pixel define thin film inside the pixel opening is removed to expose the surface of the anode 21.

Subsequently, on the base substrate on which the aforementioned patterns are formed, an organic light emitting layer 23 located in each sub-pixel is formed by evaporation or inkjet printing, and the organic light emitting layer 23 is connected to the anode 21 through the pixel opening.

Subsequently, on the base substrate on which the aforementioned patterns are formed, the pattern of the cathode 24 is formed by evaporation of an open mask plate, and the cathode 24 of the entire surface structure is connected to the organic light emitting layer 23, so that the organic light emitting layer 23 is connected to the anode 21 and the cathode 24 at the same time.

At this point, the pattern of the light emitting structure layer 30 has been prepared, as shown in FIG. 19, which is a cross-sectional view along B-B in FIG. 17.

In an exemplary embodiment, the fourth conductive thin film may adopt a metal material, a transparent conductive material, or a multilayer composite structure of a metal material and a transparent conductive material, Metal materials may include any one or more of silver (Ag), copper (Cu), aluminum (Al), titanium (Ti) and molybdenum (Mo), or alloy materials of the above metals, and transparent conductive materials may include indium tin oxide (ITO) or indium zinc oxide (IZO), the multilayer composite structure may be ITO/Al/ITO, etc.

In an exemplary implementation mode, a material of the pixel define thin film may include polyimide, acrylic, or the like. In an exemplary implementation mode, a patterning process of a half tone mask may be adopted to form a pattern of a post spacer when forming the pattern of the pixel define layer, wherein the post spacer may be disposed on an outside of the pixel opening, and the post spacer is configured to support a fine metal mask in a subsequent evaporation process. The present disclosure is not limited herein.

In an exemplary implementation mode, the organic emitting layer may include an Emitting Layer (EML), and any one or more of following: a Hole Injection Layer (HIL), a Hole Transport Layer (HTL), an Electron Block Layer (EBL), a Hole Block Layer (HBL), an Electron Transport Layer (ETL), and an Electron Injection Layer (EIL).

In an exemplary embodiment, the organic light emitting layer may be prepared in the following operation: firstly, a hole injection layer, a hole transport layer and an electron partition layer are formed in turn by an Open Mask (OPM) evaporation process or an inkjet printing process, and a common layer of the hole injection layer, the hole transport layer and the electron partition layer is formed on a display substrate. Then the evaporation process of Fine Metal Mask (FMM) or the inkjet printing process is used. Different light emitting layers are formed in different sub-pixels, and the light emitting layers of adjacent sub-pixels may have a small amount of overlap (for example, the overlapping portion accounts for less than 10% of the area of each light emitting layer pattern), or may be isolated. Subsequently, a hole block layer, an electron transport layer, and an electron injection layer are formed in sequence using an evaporation process of an open mask or an ink-jet printing process. A common layer of the hole blocking layer, the electron transport layer, and the electron injection layer is formed on the display substrate.

In an exemplary implementation mode, the organic emitting layer may include a microcavity adjustment layer, so that a thickness of the organic emitting layer between a cathode and an anode satisfies a design of a length of a microcavity. In some exemplary embodiments, a hole transport layer, an electron block layer, a hole block layer, or an electron transport layer may be used as a microcavity adjustment layer, which is not limited in the present disclosure.

In an exemplary implementation mode, an emitting layer may include a host material and a dopant material doped into the host material. A doping ratio of the dopant material of the emitting layer is 1% to 20%. Within a range of the doping ratio, on one hand, the host material of the emitting layer may effectively transfer exciton energy to the dopant material of the emitting layer to excite the dopant material of the emitting layer to emit light; on the other hand, the host material of the emitting layer "dilutes" the dopant material of the emitting layer, thus effectively improving fluorescence quenching caused by collisions between molecules of the dopant material of the emitting layer and collisions between energies, and improving a luminous efficiency and equipment life. In an exemplary implementation mode, the doping ratio refers to a ratio of a mass of the dopant material to a mass of the emitting layer, that is, a mass percentage. In an exemplary implementation mode, the host material and the dopant material may be co-evaporated through a multi-source evaporation process, so that the host material and the dopant material are uniformly dispersed in the emitting layer. A doping ratio may be adjusted by controlling an evaporation rate of the dopant material or by controlling an evaporation rate ratio of the host material to the dopant material during an evaporation process. In an exemplary implementation mode, a thickness of the emitting layer may be about 10 nm to 50 nm.

In an exemplary implementation mode, a hole injection layer may be made of an inorganic oxide, such as molybdenum oxide, titanium oxide, vanadium oxide, rhenium oxide, ruthenium oxide, chromium oxide, zirconium oxide, hafnium oxide, tantalum oxide, silver oxide, tungsten oxide, or manganese oxide, or may be made of a p-type dopant of a strongly electron withdrawing system and a dopant of a hole transport material. A thickness of the hole injection layer may be about 5nm to 20nm.

In an exemplary implementation mode, a hole transport layer may be made of a material with a relatively high hole mobility, such as an aromatic amine compound, and its substituent group may be carbazole, methylfluorene, spirofluorene, dibenzothiophene, or furan. A thickness of the hole transport layer may be about 40nm to 150nm.

In an exemplary implementation mode, a hole block layer and an electron transport layer may be made of aromatic heterocyclic compounds, such as benzimidazole derivatives, imidazopyridine derivatives, benzimidazophenanthridine derivatives, and other imidazole derivatives; pyrimidine derivatives, triazine derivatives, and other azine derivatives; quinoline derivatives, isoquinoline derivatives, phenanthroline derivatives, and other compounds containing a nitrogen-containing six-membered ring structure (further including compounds having a phosphine oxide-based substituent on a heterocyclic ring) . In an exemplary implementation mode, a thickness of the hole block layer may be about 5 nm to 15 nm, and a thickness of the electron transport layer may be about 20 nm to 50 nm.

In an exemplary implementation mode, an electron injection layer may be made of an alkali metal or a metal, such as lithium fluoride (LiF), ytterbium (Yb), magnesium (Mg), or Calcium (Ca), or a compound of these alkali metals or metals. The thickness of the electron injection layer may be about 0.5 nm to 2 nm.

In an exemplary implementation mode, the cathode may be made of any one or more of magnesium (Mg), silver (Ag), aluminum (Al), copper (Cu), and lithium (Li), or an alloy made of any one or more of the above metals.

In some possible exemplary implementation modes, a pattern of an optical coupling layer may be formed after the pattern of the cathode is formed. The optical coupling layer is disposed on the cathode. A refractive index of the optical coupling layer may be greater than a refractive index of the cathode, which facilitates light extraction and increases a light output efficiency. A material of the optical coupling layer may be an organic material, or an inorganic material, or an organic material and an inorganic material, and may be a single layer, a multi-layer, or a composite layer, which is not limited in the present disclosure.

(3) A pattern of an encapsulation structure layer is formed. In an exemplary implementation mode, forming the pattern of the encapsulation layer may include: a first encapsulation thin film is deposited by means of deposition using an open mask on the base substrate on which the above-mentioned patterns are formed to form a first encapsulation layer 31. Subsequently, the second encapsulation material is printed by an inkjet printing process using an open mask to form the second encapsulation layer 32. Subsequently, a third encapsulation thin film is deposited by using an open mask plate in a deposition manner to form a third encapsulation layer 33.

At this point, the pattern of the encapsulation structure layer is prepared, as shown in FIG. 20, which is a cross-sectional view along B-B in FIG. 17.

In an exemplary implementation mode, the first encapsulation thin film and the third encapsulation thin film may be made of any one or more of following: Silicon Oxide (SiOx), Silicon Nitride (SiNx), and Silicon Oxynitride (SiON), may be a single layer, a multi-layer, or a composite layer, which can ensure that external water and oxygen cannot enter the light emitting structure layer, and the deposition method may be Chemical Vapor Deposition (CVD) or Atomic Layer Deposition (ALD). The second encapsulation thin film may be made of an organic material, such as resin, etc., playing a role of covering each film layer of the display substrate so as to improve structural stability and flatness.

(4) Patterns of a touch control structure layer, a color filter structure layer and a light-taking structure layer are formed in turn.

In an exemplary embodiment, forming the pattern of the touch control structure layer may include: on the base substrate on which the aforementioned patterns are formed, a first touch insulation layer is formed first, then a metal grid layer is formed through a patterning process, and then a second touch insulation layer covering the metal grid layer is formed.

In an exemplary embodiment, forming the pattern of the color filter structure layer may include: a black matrix thin film is coated on the base substrate on which the aforementioned patterns are formed, the black matrix thin film is patterned through a patterning process to form a pattern of the black matrix, which may at least include multiple black matrices, the multiple black matrices may be arranged at intervals, and light-transmissive openings are formed between adjacent black matrices. Subsequently, a red filter thin film, a blue filter thin film and a green filter thin film are sequentially coated, and the red filter thin film, the blue filter thin film and the green filter thin film are respectively patterned through a patterning process, so that multiple light filter layers are respectively formed in the light-transmissive opening formed by the black matrix.

In an exemplary embodiment, forming the pattern of the light-taking structure layer may include: on the base substrate on which the aforementioned patterns are formed, a first cover thin film is firstly deposited or coated to form a first cover layer covering the color filter structure layer. Subsequently, multiple first light-taking structures are formed on the first cover layer through a patterning process, or multiple second light-taking structures are formed on the first cover layer through a patterning process, or multiple first light-taking structures and multiple second light-taking structures are formed on the first cover layer through a patterning process. Subsequently, a second cover thin film is deposited or coated to form a second cover layer 72 covering multiple light-taking structures.

In an exemplary embodiment, the formation of the second cover layer 72 may further include: multiple third light-taking structures are formed through a patterning process, the third light-taking structures may be a microlens group, the microlens group may include multiple microlenses arranged in sequence, and then a third cover layer covering the multiple third light-taking structures is formed.

The structure and preparation process of the display substrate shown in an exemplary embodiment of the present disclosure are merely illustrative. In practical implementation, a corresponding structure may be changed and a patterning process may be increased or decreased according to actual needs, which is not limited in the present disclosure.

It is found that the existing electronic apparatuses have some problems, such as low light output efficiency in the off-screen camera region. As may be seen from the structure and the preparation process of the display substrate of the exemplary embodiment of the present disclosure, the present disclosure deflects the outgoing light to the direction of the center of the sub-pixel by arranging the light-taking structure layer in the first display region, thus effectively improving the light output efficiency of the sub-pixel, improving the light output color gamut and improving the display quality. In one aspect, the light-taking structure layer includes a first light-taking structure that deflects the outgoing light rays in the direction of the center of the sub-pixel by refraction. In another scheme, the light-taking structure layer includes a second light-taking structure that deflects the outgoing light rays in the direction of the center of the sub-pixel using total reflection. In yet another aspect, the light-taking structure layer includes a first light-taking structure and a second light-taking structure, and deflects the outgoing light rays in the direction of the center of the sub-pixel using refraction and total reflection.

By arranging the light-taking structure layer close to the base substrate, the light emitted from the display structure layer is modulated before entering the color filter structure layer, which can improve the efficiency of modulating the light and further improve the light emitting efficiency of sub-pixels. By arranging the microlens group, the invention can further improve the light emitting efficiency of sub-pixels, further improve the light emitting color gamut and further improve the display quality.

In the present disclosure, by setting up a filter and light-taking multiplexing structure for multiplexing the light filtering structure and the light-taking structure, it not only can effectively improve the light output efficiency of sub-pixels, but also can effectively reduce the thickness of a display substrate, which is beneficial to achieving an ultra-thin display apparatus.

By configuring the probability of total reflection in different sub-pixels, the invention can effectively avoid bluing in a large viewing angle. By using the black matrix to block the metal wire in the touch control structure layer, the invention can effectively avoid the reflection of the metal wire and improve the display quality.

By setting the light-scattering structure, the invention can effectively increase the scattering of the edge of the pixel island and the region where the signal connection line is located, effectively reduce the display difference between the first display region and the second display region, and further improve the display quality to the maximum extent.

The preparation method according to the present disclosure does not need to change the existing process flow or process equipment, has little improvement on the existing process, can be well compatible with the existing preparation process, and has high process realizability and strong practicability.

In an exemplary implementation, the display substrate of the present disclosure may be applied to a electronic apparatus with a pixel drive circuit, such as an OLED, a quantum dot display (QLED), a light emitting diode display (Micro LED or Mini LED) or a quantum dot light emitting diode display (QDLED), etc., which is not limited here in the present disclosure.

An embodiment of the present disclosure further provides a method for preparing a display substrate to prepare the display substrate of the foregoing exemplary embodiments. In an exemplary embodiment, the display substrate includes a first display region and a second display region, the second display region at least partially surrounds the first display region, the first display region is configured to perform image display and make light pass through, and the second display region is configured to perform image display; the preparation method may include:

forming a display structure layer on the base substrate of the first display region; and

forming a light-processing layer on the display structure layer, and the light-processing layer at least includes a light extraction structure for improving light output efficiency.

The invention further provides a display apparatus, The display apparatus includes an camera apparatus and the aforementioned display substrate. An orthographic projection of the camera apparatus on the display substrate at least partially overlaps with an orthographic projection of the first display region on the display substrate, and an orthographic projection of the camera apparatus on the display substrate does not overlap with an orthographic projection of the second display region on the display substrate.

In an exemplary implementation, the display apparatus may be any product or component with a display function, such as a mobile phone, a tablet computer, a television, a display, a notebook computer, a digital photo frame, or a navigator, and the embodiments of the present invention are not limited thereto.

Although the implementation modes disclosed in the present disclosure are as above, the described contents are only implementation modes used for convenience of understanding the present disclosure and are not intended to limit the present disclosure. Any person skilled in the art to which the present disclosure pertains may make any modification and variation in implementation forms and details without departing from the spirit and scope disclosed in the present disclosure. However, the scope of patent protection of the present disclosure is still subject to the scope defined by the appended claims.

**Claims**

1. A display substrate comprising a first display region and a second display region, wherein the second display region at least partially surrounds the first display region, the first display region is configured to perform image display and make light pass through, and the second display region is configured to perform image display; in a plane perpendicular to the display substrate, the first display region at least comprises a display structure layer disposed on a base substrate and a light-processing layer disposed on a side of the display structure layer away from the base substrate, and the light-processing layer at least comprises a light-taking structure for improving light output efficiency.

2. The display substrate according to claim 1, wherein the light-processing layer at least comprises a color filter structure layer and a first light-taking structure layer, the color filter structure layer at least comprises a plurality of light filter layers and a black matrix arranged between the light filter layers, the first light-taking structure layer at least comprises a first cover layer, a plurality of first light-taking structures arranged on a side of the first cover layer away from the base substrate, and a second cover layer arranged on a side of the first light-taking structure away from the base substrate, at least one first light-taking structure comprises a plano-convex convex lens.

3. The display substrate according to claim 2, wherein the color filter structure layer is disposed on a side of the display structure layer away from the base substrate, and the first light-taking structure layer is disposed on a side of the color filter structure layer away from the base substrate.

4. The display substrate according to claim 2, wherein the first light-taking structure layer is arranged on a side of the display structure layer away from the base substrate, and the color filter structure layer is arranged on a side of the first light-taking structure layer away from the base substrate.

5. The display substrate according to claim 2, wherein an orthographic projection of the first light-taking structure on the base substrate is within a range of the light filter layer.

6. The display substrate according to claim 2, wherein the first cover layer has a first refractive index, the second cover layer has a second refractive index, the first light-taking structure has a first light-taking refractive index, the first light-taking refractive index is greater than or equal to the first refractive index, and the first light-taking refractive index is greater than the second refractive index.

7. The display substrate according to claim 2, wherein the first light-taking structure has a first height, the second cover layer has a cover thickness, and a ratio of the first height to the cover thickness is 1/3 to 1/1.1.

8. The display substrate according to claim 2, wherein the light-processing layer further comprises a third light-taking structure layer, the third light-taking structure layer comprises a plurality of third light-taking structures disposed on a side of the first light-taking structure layer away from the base substrate and a third cover layer disposed on a side of the plurality of third light-taking structures away from the base substrate, at least one of the third light-taking structures comprises a microlens group, and at least one microlens group comprises a plurality of microlenses arranged in sequence.

9. The display substrate according to claim 8, wherein an orthographic projection of the third light-taking structure on the base substrate is within a range of the light filter layer.

10. The display substrate according to claim 1, wherein the light-processing layer at least comprises a color filter structure layer and a second light-taking structure layer, the color filter structure layer at least comprises a plurality of light filter layers and a black matrix arranged between the light filter layers, the second light-taking structure layer at least comprises a first cover layer, a plurality of second light-taking structures arranged on a side of the first cover layer away from the base substrate, and a second cover layer arranged on a side of the plurality of second light-taking structures away from the base substrate, at least one second light-taking structure comprises a prism with a trapezoidal cross section.

11. The display substrate according to claim 10, wherein the color filter structure layer is disposed on a side of the display structure layer away from the base substrate, and the second light-taking structure layer is disposed on a side of the color filter structure layer away from the base substrate.

12. The display substrate according to claim 10, wherein the second light-taking structure layer is arranged on a side of the display structure layer away from the base substrate, and the color filter structure layer is arranged on a side of the second light-taking structure layer away from the base substrate.

13. The display substrate according to claim 10, wherein an orthographic projection of the black matrix on the base substrate is within a range of an orthographic projection of the second light-taking structure on the base substrate.

14. The display substrate according to claim 10, wherein the second cover layer has a second refractive index, and the second light-taking structure has a second light-taking refractive index, and the second light-taking refractive index is less than the second refractive index.

15. The display substrate according to claim 10, wherein the second light-taking structure has a second height, the second cover layer has a cover thickness, and a ratio of the second height to the cover thickness is 1/3 to 1/1.2.

16. The display substrate according to claim 10, wherein a sidewall of the second light-taking structure has a gradient angle, the gradient angle is greater than 60° and less than 90°.

17. The display substrate according to claim 16, wherein the display substrate comprises a plurality of sub-pixels in a plane parallel to the base substrate, and an orthographic projection of at least one sub-pixel on the base substrate at least partially overlaps with orthographic projections of two second light-taking structures on the base substrate.

18. The display substrate according to claim 17, wherein the plurality of sub-pixels at least comprise red sub-pixels, blue sub-pixels and green sub-pixels, the sidewall of the second light-taking structure located in a region where the red sub-pixel is located has a first gradient angle, the sidewall of the second light-taking structure located in a region where the blue sub-pixel is located has a second gradient angle, and the sidewall of the second light-taking structure located in a region where the green sub-pixel is located has a third gradient angle, wherein the first gradient angle is less than the second gradient angle, and the first gradient angle is less than the third gradient angle.

19. The display substrate according to claim 1, wherein the light-processing layer at least comprises a color filter structure layer and a composite light-taking structure layer, the color filter structure layer at least comprises a plurality of light filter layers and a black matrix arranged between the light filter layers, the composite light-taking structure layer at least comprises a first cover layer, a plurality of first light-taking structures and a plurality of second light-taking structures arranged on a side of the first cover layer away from the base substrate, and a second cover layer arranged on a side of the plurality of first light-taking structures and the plurality of second light-taking structures away from the base substrate, at least one first light-taking structure comprises a plano-convex convex lens, and at least one second light-taking structure comprises a prism with a trapezoidal cross section.

20. The display substrate according to claim 19, wherein the color filter structure layer is disposed on a side of the display structure layer away from the base substrate, and the composite light-taking structure layer is disposed on a side of the color filter structure layer away from the base substrate.

21. The display substrate according to claim 19, wherein the composite light-taking structure layer is arranged on a side of the display structure layer away from the base substrate, and the color filter structure layer is arranged on a side of the composite light-taking structure layer away from the base substrate.

22. The display substrate according to claim 19, wherein an orthographic projection of the first light-taking structure on the base substrate is within a range of an orthographic projection of the light filter layer on the base substrate, and an orthographic projection of the black matrix on the base substrate is within a range of an orthographic projection of the second light-taking structure on the base substrate.

23. The display substrate according to claim 19, wherein the first cover layer has a first refractive index, the second cover layer has a second refractive index, the first light-taking structure has a first light-taking refractive index, the second light-taking structure has a second light-taking refractive index, the first light-taking refractive index is greater than or equal to the first refractive index, the first light-taking refractive index is greater than the second refractive index, and the second light-taking refractive index is less than the second refractive index.

24. The display substrate according to claim 1, wherein the light-processing layer at least comprises a color filter lens structure layer, and the color filter lens structure layer is a filtering and light-taking multiplex structure integrating a filtering structure and a light-taking structure.

25. The display substrate according to claim 24, wherein the color filter lens structure layer at least comprises a black matrix, a first color filter layer, a second color filter layer, and a light filter lens layer; the black matrix is arranged at intervals on one side of the display structure layer away from the base substrate, and light-transmissive openings are formed between adjacent black matrices; the first color filter layer is respectively arranged in a plurality of light-transmissive openings, and a surface of the first color filter layer away from the base substrate is provided with an arc-shaped concave; the light filter lens layer is respectively arranged on the first color filter layer in a plurality of light-transmissive openings, and a lower surface of an arc-shaped convex in the light filter lens layer is attached to an upper surface of the arc-shaped concave in the first color filter layer; and the second color filter layer is disposed on a side of the plurality of black matrices and the plurality of light filter lens layers away from the base substrate.

26. The display substrate according to claim 25, wherein the first color filter layer has a first color filter refractive index, the second color filter layer has a second color filter refractive index, the light filter lens layer has a light filter lens refractive index, the light filter lens refractive index is greater than the first color filter refractive index, and the light filter lens refractive index is less than the second color filter refractive index.

27. The display substrate according to any one of claims 1 to 26, wherein the display structure layer at least comprises a drive circuit layer arranged on the base substrate, a light emitting structure layer arranged on a side of the drive circuit layer away from the base substrate, an encapsulation structure layer arranged on a side of the light emitting structure layer away from the base substrate, and a touch control structure layer arranged on a side of the encapsulation structure layer away from the base substrate, the touch control structure layer at least comprises a metal grid layer, the metal grid layer comprises a plurality of metal wires interwoven with each other, and an orthographic projection of the metal wires on the base substrate is within at least a range of the orthographic projection of the black matrix in the light-processing layer on the base substrate.

28. The display substrate according to any one of claims 1 to 26, wherein the first display region comprises a plurality of pixel islands and a plurality of blank islands, in a first direction, the pixel islands and the blank islands are arranged alternately, in a second direction, the pixel islands and the blank islands are arranged alternately, and the first direction and the second direction intersect.

29. The display substrate according to claim 28, wherein at least one pixel island comprises two pixel units, the pixel unit comprises one red sub-pixel emitting red light, one blue sub-pixel emitting blue light and two green sub-pixels emitting green light, two red sub-pixels are respectively located at one diagonal position of the pixel island, two blue sub-pixels are respectively located at another diagonal position of the pixel island, and four green sub-pixels are respectively located in the middle of the second direction of the pixel island.

30. The display substrate according to claim 28, wherein the blank island is provided with at least one light-scattering structure, the light-scattering structure comprises a plurality of micro-protrusions arranged in sequence, a shape of the micro-protrusion comprises any one or more of triangular, rectangular, pentagonal, hexagonal, circular and elliptical in a plane parallel to the base substrate, and a cross-sectional shape of the micro-protrusion comprises triangular or trapezoidal in a plane perpendicular to the base substrate.

31. The display substrate according to claim 30, wherein the light-scattering structure comprises a first light-scattering strip respectively arranged on both sides of the pixel island in the second direction and a second light-scattering strip respectively arranged on both sides of the pixel island in the first direction, a shape of the first light-scattering strip is a strip shape extending along the first direction, and a shape of the second light-scattering strip is a strip shape extending along the second direction.

32. The display substrate according to claim 31, wherein the light-scattering structure further comprises a third light-scattering strip connected to the first light-scattering strip and the second light-scattering strip respectively, the first light-scattering strip, the second light-scattering strip and the third light-scattering strip are sequentially connected to form a ring-shaped light-scattering structure surrounding the pixel island.

33. The display substrate according to claim 32, wherein the light-scattering structure further comprises a first connection strip and a second connection strip, the first connection strip is disposed between adjacent first light-scattering strips in the second direction, and is connected with the first light-scattering strip, a connection channel is formed between the light-scattering structures adjacent to each other in the second direction, the second connection strips is disposed between adjacent second light-scattering strips in the first direction and is connected with the second light-scattering strips to form light-scattering structures that surround the pixel islands and communicate with each other, and a connection channel is formed between the light-scattering structures adjacent to each other in the first direction.

34. An electronic apparatus, comprising a camera apparatus and the display substrate according to any one of claims 1 to 33, an orthographic projection of the camera apparatus on the display substrate at least partially overlaps with an orthographic projection of the first display region on the display substrate, and the orthographic projection of the camera apparatus on the display substrate does not overlap with an orthographic projection of the second display region on the display substrate.

35. A method of preparing a display substrate, wherein the display substrate comprises a first display region and a second display region, the second display region at least partially surrounds the first display region, the first display region is configured to perform image display and make light pass through, and the second display region is configured to perform image display; the method comprises:

forming a display structure layer on the base substrate of the first display region; and
forming a light-processing layer on the display structure layer, and the light-processing layer at least comprises a light-taking structure for improving light output efficiency.

FIG. 1

FIG. 2

FIG. 3

FIG. 4

FIG. 5

FIG. 6

FIG. 7

FIG. 8

FIG. 9

72    74    71    61    62

50

60

80

10    20    30    40

FIG. 10

72  71  73    74    61  62

50

60

75

10    20    30    40

FIG. 11

FIG. 12

FIG. 13

FIG. 14

FIG. 15

FIG. 16

FIG. 17

20 {

300

10    101A  101B

## FIG. 18

24    23    22    21

30 {
20 {

300                                      10    101A  101B

## FIG. 19

33    32    31

40 {
30 {
20 {

300                                      10    101A  101B

## FIG. 20

## INTERNATIONAL SEARCH REPORT

| | International application No. |
|---|---|
| | **PCT/CN2022/094867** |

| A. | CLASSIFICATION OF SUBJECT MATTER |
|---|---|

H01L 27/32(2006.01)i

According to International Patent Classification (IPC) or to both national classification and IPC

| B. | FIELDS SEARCHED |
|---|---|

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNABS, CNTXT: 全面屏, 屏下摄像, 屏下摄影, 第二显示区, 透光显示区, 透明显示区, 副显示区, 功能显示区, 取光元件, 取光结构, 取光器件, 透镜, 聚光元件, 聚光结构, 聚光器件, 像素岛, 散光, 散射; VEN, USTXT, EPTXT: full display, full screen, under display, second display area, transparent display area, function display area, lens, light collector, pixel islands, scatter, dispersion

| C. | DOCUMENTS CONSIDERED TO BE RELEVANT |
|---|---|

| Category* | Citation of document, with indication, where appropriate, of the relevant passages | Relevant to claim No. |
|---|---|---|
| E | CN 114823807 A (WUHAN CHINA STAR OPTOELECTRONICS SEMICONDUCTOR DISPLAY TECHNOLOGY CO., LTD.) 29 July 2022 (2022-07-29) description, paragraphs 43-87, and figures 1-10 | 1, 28, 34-35 |
| X | CN 113363305 A (BOE TECHNOLOGY GROUP CO., LTD.) 07 September 2021 (2021-09-07) description, paragraphs 74-181, and figures 1-8b | 1-5, 7-9, 27-28, 34-35 |
| Y | CN 113363305 A (BOE TECHNOLOGY GROUP CO., LTD.) 07 September 2021 (2021-09-07) description, paragraphs 74-181, and figures 1-8b | 6, 10-26, 29-33 |
| X | CN 113270562 A (BOE TECHNOLOGY GROUP CO., LTD. et al.) 17 August 2021 (2021-08-17) description, paragraphs 46-104, and figures 1-10 | 1-9, 27-28, 34-35 |
| Y | CN 113270562 A (BOE TECHNOLOGY GROUP CO., LTD. et al.) 17 August 2021 (2021-08-17) description, paragraphs 46-104, and figures 1-10 | 6, 10-26, 29-33 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **01 December 2022** | **04 January 2023** |

| Name and mailing address of the ISA/CN | Authorized officer |
|---|---|
| **China National Intellectual Property Administration (ISA/CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2022/094867**

**C.    DOCUMENTS CONSIDERED TO BE RELEVANT**

| Category* | Citation of document, with indication, where appropriate, of the relevant passages | Relevant to claim No. |
|---|---|---|
| Y | CN 216145641 U (BOE TECHNOLOGY GROUP CO., LTD. et al.) 29 March 2022 (2022-03-29)<br>    description, paragraph 50, and figure 2 | 10-23 |
| Y | CN 113644219 A (BOE TECHNOLOGY GROUP CO., LTD. et al.) 12 November 2021 (2021-11-12)<br>    description, paragraphs 55-56, and figure 4 | 24-26 |
| Y | CN 114005865 A (BEIJING BOE TECHNOLOGY DEVELOPMENT CO., LTD. et al.) 01 February 2022 (2022-02-01)<br>    description, paragraphs 67-73, and figures 1-3 | 29-33 |
| Y | CN 112234082 A (GUANGDONG OPPO MOBILE COMMUNICATIONS CO., LTD.) 15 January 2021 (2021-01-15)<br>    description, paragraphs 31-67, and figures 1-8 | 30-33 |
| A | CN 114267702 A (HUAWEI TECHNOLOGIES CO., LTD.) 01 April 2022 (2022-04-01)<br>    entire document | 1-35 |
| A | KR 20170005248 A (LG DISPLAY CO., LTD.) 12 January 2017 (2017-01-12)<br>    entire document | 1-35 |

Form PCT/ISA/210 (second sheet) (January 2015)

INTERNATIONAL SEARCH REPORT
Information on patent family members

International application No.

**PCT/CN2022/094867**

| Patent document cited in search report | | | Publication date (day/month/year) | Patent family member(s) | | | Publication date (day/month/year) |
|---|---|---|---|---|---|---|---|
| CN | 114823807 | A | 29 July 2022 | None | | | |
| CN | 113363305 | A | 07 September 2021 | None | | | |
| CN | 113270562 | A | 17 August 2021 | CN | 216488148 | U | 10 May 2022 |
| CN | 216145641 | U | 29 March 2022 | None | | | |
| CN | 113644219 | A | 12 November 2021 | None | | | |
| CN | 114005865 | A | 01 February 2022 | CN | 114005865 | B | 22 March 2022 |
| CN | 112234082 | A | 15 January 2021 | CN | 112234082 | | 15 November 2022 |
| CN | 114267702 | A | 01 April 2022 | None | | | |
| KR | 20170005248 | A | 12 January 2017 | KR | 101951276 | B1 | 22 February 2019 |
| | | | | KR | 20180015697 | A | 13 February 2018 |
| | | | | KR | 101827399 | B1 | 09 February 2018 |

Form PCT/ISA/210 (patent family annex) (January 2015)